# EUROPEAN PATENT SPECIFICATION

(11) **EP 4 414 673 B1**
(45) Date of publication and mention of the grant of the patent: **31.12.2025**
(21) Application number: 23155987.3
(22) Date of filing: 10.02.2023
(51) Int. Cl.: G01K 1/02, G01J 5/00, G01R 31/00, H02B 13/00, G01K 3/00, G01K 3/10, G06N 20/00, G01K 3/14, G01R 31/327, H02B 13/065

(54) **SYSTEM, METHOD, AND COMPUTER PROGRAM ELEMENT FOR MONITORING A SWITCHGEAR**
SYSTEM, VERFAHREN UND COMPUTERPROGRAMMELEMENT ZUR ÜBERWACHUNG EINER SCHALTANLAGE
SYSTÈME, PROCÉDÉ ET ÉLÉMENT DE PROGRAMME INFORMATIQUE DE SURVEILLANCE D'UN APPAREILLAGE DE COMMUTATION

(43) Date of publication of application: 14.08.2024
(73) Proprietor: ABB SCHWEIZ AG, 5400 Baden (CH)
(72) Inventor: GITZEL, Ralf, 68165 Mannheim (DE); BOYACI, Aydin, 76137 Karlsruhe (DE); OSTROWSKI, Joerg, 8048 Zürich (CH)
(74) Representative: Maiwald GmbH

(56) References cited:
- CN-A- 109 932 594
- CN-B- 102 829 885
- IDERUS SAMAT ET AL: "Temperature Rise Test on Medium Voltage Switchgear Assembly Based on IEC Standard", 2020 8TH INTERNATIONAL CONFERENCE ON ORANGE TECHNOLOGY (ICOT), IEEE, 18 December 2020 (2020-12-18), pages 1 - 5, XP033937777, DOI: 10.1109/ICOT51877.2020.9468746
- XIA HAOTIAN ET AL: "Temperature rise test and analysis of high current switchgear in distribution system", THE JOURNAL OF ENGINEERING, THE INSTITUTION OF ENGINEERING AND TECHNOLOGY, MICHAEL FARADAY HOUSE, SIX HILLS WAY, STEVENAGE, HERTS. SG1 2AY, UK, vol. 2019, no. 16, 1 March 2019 (2019-03-01), pages 754 - 757, XP006084814, DOI: 10.1049/JOE.2018.8371
- LI JIANGTAO ET AL: "A Novel Contact Temperature Calculation Algorithm in Distribution Switchgears for Condition Assessment", IEEE TRANSACTIONS ON COMPONENTS, PACKAGING AND MANUFACTURING TECHNOLOGY, IEEE, USA, vol. 9, no. 2, 1 February 2019 (2019-02-01), pages 279 - 287, XP011707635, ISSN: 2156-3950, [retrieved on 20190131], DOI: 10.1109/TCPMT.2018.2886404

## Description

### FIELD OF THE INVENTION

The present invention relates to a system for monitoring a switchgear, a method for monitoring a switchgear, and a computer program element.

### BACKGROUND OF THE INVENTION

Electrical equipment such as switchgear can suffer from small faults that change the electrical resistance of the system. These faults manifest as hot spots and can ultimately lead to catastrophic failures. Here a switchgear can be a high voltage, medium voltage, or low voltage switchgear.

S. Iderus and G. Peter, "Temperature Rise Test on Medium Voltage Switchgear Assembly Based on IEC Standard", 2020 8th International Conference on Orange Technology, 18 December 2020, pages 1-5, uses thermocouples to measure the temperatures of each phase of a three phase switchgear.

Thus, temperature sensors can be used to determine the state of such equipment (condition monitoring). The most commonly available sensors are thermal point sensors that measure the temperature at a specific position. A network of multiple point sensors can give a good description of the equipment's state.

One solution is to monitor parts of the switchgear, such as the phases, with an infrared thermographic camera to detect the hot spots. This is because infrared (IR) images can be used to identify technical problems within electrical equipment (e.g. switchgear) that lead to the overheating of components and to identify the hot spots themselves.

Temperature condition monitoring data can be interpretated by defining a temperature threshold for each of the phases of the equipment. If the threshold is exceeded, an alarm is raised.

However, such techniques do not provide early warnings of problems as they develop, and do not provide details on the cause of the problem.

There is a need to address these issues.

### SUMMARY OF THE INVENTION

Therefore, it would be advantageous to have an improved system for monitoring a switchgear.

The object of the present invention is solved with the subject matter of the independent claims, wherein further embodiments are incorporated in the dependent claims. It is to be noted that the system is described with respect to a switchgear, but finds utility in other electrical system than can suffer from components that overheat.

The independent claims define the invention and its scope of protection. The dependent claims define embodiments of the invention.

The following aspects and examples of the summary provide examples of how technical subject matters can be combined.

In an aspect, there is provided a system for monitoring a three phase switchgear, the system comprising:
- at least one temperature sensor;
- a processing unit;
- at least three current sensors; and
- an output unit.

One or more of the at least one temperature sensor is configured to acquire first temperature data for each location of at least one location of a first phase of a switchgear at n time points. One or more of the at least one temperature sensor is configured to acquire second temperature data for each location of at least one location of a second phase of the switchgear at the n time points. One or more of the at least one temperature sensor is configured to acquire third temperature data for each location of at least one location of a third phase of the switchgear at the n time points. The at least one temperature sensor is configured to provide the first temperature data, the second temperature data, and the third temperature data to the processing unit. One or more first current sensors of the at least three current sensors are configured to acquire first electrical current data for at least one location of the first phase of the switchgear at the n time points. One or more second current sensors of the at least three current sensors are configured to acquire second electrical current data for at least one location of the second phase of the switchgear at the n time points. One or more third current sensors of the at least three current sensors are configured to acquire third electrical current data for at least one location of the third phase of the switchgear at the n time points. The at least three current sensors are configured to provide the first electrical current data, the second electrical current data, and the third electrical current data to the processing unit.

The processing unit is configured to determine n-1 first rates of change of temperature for one or more locations of the at least one location of the first phase with respect to the n first temperature data for the one or more locations of the first phase at the n time points. The processing unit is configured to determine n-1 second rates of change of temperature for one or more locations of the at least one location of the second phase with respect to the n second temperature data for the one or more locations of the second phase at the n time points. The processing unit is configured to determine n-1 third rates of change of temperature for one or more locations of the at least one location of the third phase with respect to the n third temperature data for the one or more locations of the third phase at the n time points. The processing unit is configured to determine n-1 first correlation data points, wherein each first correlation data point is a correlation between each first rate of change of temperature of the n-1 first rates of change of temperature with an associated first temperature and an associated first electrical current data, wherein the associated first electrical current data is one of the two first electrical current data at the two time points when the two first temperature data were acquired that were used to calculate the associated first rate of change of temperature or the associated first electrical current data is an average of the two first electrical current data at the two time points when the two first temperature data were acquired that were used to calculate the associated first rate of change of temperature, wherein for a particular first rate of change of temperature the associated first temperature is a first temperature of two first temperatures used to determine the particular first rate of change of temperature or is a second temperature of the two first temperatures used to determine the particular first rate of change of temperature or is an average of the first temperature and second temperature of the two first temperatures used to determine the particular first rate of change of temperature. The processing unit is configured to determine n-1 second correlation data points, wherein each second correlation data point is a correlation between each second rate of change of temperature of the n-1 second rates of change of temperature with an associated second temperature and an associated second electrical current data, wherein the associated second electrical current data is one of the two second electrical current data at the two time points when the two second temperature data were acquired that were used to calculate the associated second rate of change of temperature or the associated second electrical current data is an average of the two second electrical current data at the two time points when the two second temperature data were acquired that were used to calculate the associated second rate of change of temperature, wherein for a particular second rate of change of temperature the associated second temperature is a first temperature of two second temperatures used to determine the particular second rate of change of temperature or is a second temperature of the two second temperatures used to determine the particular second rate of change of temperature or is an average of the first temperature and second temperature of the two second temperatures used to determine the particular second rate of change of temperature.The processing unit is configured to determine n-1 third correlation data points, wherein each third correlation data point is a correlation between each third rate of change of temperature of the n-1 third rates of change of temperature with an associated third temperature and an associated third electrical current data, wherein the associated third electrical current data is one of the two third electrical current data at the two time points when the two third temperature data were acquired that were used to calculate the associated third rate of change of temperature or the associated third electrical current data is an average of the two third electrical current data at the two time points when the two third temperature data were acquired that were used to calculate the associated third rate of change of temperature, wherein for a particular third rate of change of temperature the associated third temperature is a first temperature of two third temperatures used to determine the particular third rate of change of temperature or is a second temperature of the two third temperatures used to determine the particular third rate of change of temperature or is an average of the first temperature and second temperature of the two third temperatures used to determine the particular third rate of change of temperature. The processing unit is configured to determine a state of the switchgear. The determination of the state of the switchgear comprises utilization of the n-1 first rates of change of temperature for the one or more locations of the first phase and at least n-1 of the n first temperature data for the one or more locations of the first phase and the n-1 second rates of change of temperature for the one or more locations of the second phase and at least n-1 of the n second temperature data for the one or more locations of the second phase and the n-1 third rates of change of temperature for the one or more locations of the third phase and at least n-1 of the n third temperature data for the one or more locations of the third phase and at least n-1 of the n first electrical current data for the one or more locations of the first phase and at least n-1 of the n second electrical current data for the one or more locations of the second phase and at least n-1 of the n third electrical current data for the one or more locations of the third phase and the n-1 first correlation data points and the n-1 second correlation data points and the n-1 third correlation data points. The output unit is configured to output the determined state of the switchgear when the determined state of the switchgear is determined not to be normal or not to be healthy. Here not to be healthy is equivalent to not to be normal.

Thus, temperature data for a specific location, for example that with a maximum temperature of for example a phase of a three-phase system, is acquired along with rate of change temperature, or temperature gradient data, as a function of time for the location of the first phase. Thus, for example, two temperatures for a location of the first phase (e.g. that is determined to have a maximum temperature for the first phase) can be acquired at two consecutive time points, from which a rate of change of temperature is determined for the location of the first phase. Then one of the two temperatures, along with the rate of change of temperature is used for further processing. Similar, for both the second and third phases, temperature data at the two consecutive time points is acquired, again for example for a locations of these phases that has a maximum temperature, and a rate of change of temperature for each phase is determined. Then again, one of the two temperatures for each phase and the rate of change of temperature is used for further processing. There is then a dataset of 6 points, a temperature and a rate of change of temperature, associated with for example a location of a maximum temperature for each phase, and these 6 data points are sufficient to characterize if the operation of one of the phases is abnormal, for example where overheating due to hot spot developing as a consequence of a loose joint of other increased resistance, or it can be determined that all the phases exhibit overheating, for example due to a higher than normal electrical current load.

Here, n is equal to 2, but it can be 5, 10, 20 ... 500 etc. Thus, rather than single values of temperature, and rate of change of temperature, in effect at the same time point for each phase being utilized, a time series of the temperature values and rates of change of temperature values can be utilized.

The manner in which all of this data changes with time is used to indicate if a problem is occurring at the location, for example a hot spot has developed or is in the process of developing, because this 3D data set provides a "fingerprint" that can be used to determine if the operation is normal or abnormal. The determination of normal or abnormal operation can be made using reference data in some manner, for example via a relatively simple comparison of the acquired 3D data set with reference 3D data or a more complex utilization of a trained machine learning algorithm, such as a neural network. The determination of normal or abnormal operation with respect to a phase of the switch gear can be made by comparing the 3D data set for this phase and the other phases with equivalent data for phases of for example a reference three-phase system.

However, at one level a simple comparison of the temperature data and associated rate of change of temperature ( 2 data points as discussed above) with the same data for the other two phases can show that one of the phases is behaving abnormally and that a hot spot is developing.

To put this another way, as phases of a switchgear heat up, the temperatures and rates of temperatures of phases provide a temporally varying 3D set of data that should change in a way that can signify that there is no problem with the parts of the switchgear, and likewise indicate when there is a problem.

It is to be noted that a single infrared camera could be monitoring all three phases in a compartment, and two images (that could be consecutive images) and used to identified and determine temperatures at locations at each of the three phases (for example a maximum temperature for each phase) and a rate of change of temperature is determined for the location for each phase. However, three infrared cameras could be used, where each camera is monitoring a different phase. However, each phase could have an array of temperature sensors (point sensors) arranged at different locations, and one of these point sensors per phase (for example at a maximum temperature location for a phase) can be used to determine two temperature values (for example consecutive values) from which a rate of change of temperature is determined for each phase at this location.

Thus, the one or more temperature sensors that acquire the first temperature data at different locations of the first phase can be a single sensor (IR camera).

Thus, the one or more temperature sensors that acquire the second temperature data at different locations of the second phase can be a single sensor (IR camera).

Thus, the one or more temperature sensors that acquire the third temperature data at different locations of the third phase can be a single sensor (IR camera).

The same IR camera can acquire all of the this temperature data, or different IR cameras can acquire temperature data for each phase at different locations.

However, each phase can have one or more different points sensors that acquire temperature data at one or more different locations. Thus, for example each phase can have a plurality of point temperature sensors (such as thermocouples) located at different locations of the phase.

In an example, the one or more of the at least one temperature sensor is configured to acquire first temperature data for each location of the at least one location of the first phase at m time points, where m is greater than n, and the n time points are consecutive time points of the m time points.

In an example, the one or more of the at least one temperature sensor is configured to acquire second temperature data for each location of the at least one location of the second phase at the m time points, where m is greater than n, and the n time points are consecutive time points of the m time points.

In an example, the one or more of the at least one temperature sensor is configured to acquire third temperature data for each location of the at least one location of the third phase at the m time points, wherein m is greater than n, and wherein the n time points are consecutive time points of the m time points.

The m and n time points can be the same time points with respect to the temperature sensing of locations of the three phases.

In other words, the system can in effect be acquiring temperature data in real time at time steps, and temperature gradient or rate of change of temperatures are determined for each temperature data point as it is acquired, for example via a comparison with the previously acquired temperature point for that location. Then a time window of n data points of temperature data yields n-1 temperature gradient points, and these temperature gradient points can be analysed along with n-1 (or indeed all of the n temperature data points) to determine a state of the switchgear, and this is done for each phase with respect to a location of each phase, that could for example be the location that has the maximum temperature for that phase.

In an example, each of the n-1 first rates of change of temperature are determined for consecutive temperature data of the n first temperature data for the one or more locations of the first phase.

In an example, each of the n-1 second rates of change of temperature are determined for consecutive temperature data of the n second temperature data for the one or more locations of the second phase.

In an example, each of the n-1 third rates of change of temperature are determined for consecutive temperature data of the n third temperature data for the one or more locations of the third phase.

According to the invention, the processing unit is configured to determine n-1 first correlation data points, where each first correlation data point is a correlation between each first rate of change of temperature of the n-1 first rates of change of temperature with an associated first temperature. For a particular first rate of change of temperature the associated first temperature is a first temperature of two first temperatures used to determine the particular first rate of change of temperature or is a second temperature of the two first temperatures used to determine the particular first rate of change of temperature or is an average of the first temperature and second temperature of the two first temperatures used to determine the particular first rate of change of temperature.

According to the invention, the processing unit is configured to determine n-1 second correlation data points, where each second correlation data point is a correlation between each second rate of change of temperature of the n-1 second rates of change of temperature with an associated second temperature. For a particular second rate of change of temperature the associated second temperature is a first temperature of two second temperatures used to determine the particular second rate of change of temperature or is a second temperature of the two second temperatures used to determine the particular second rate of change of temperature or is an average of the first temperature and second temperature of the two second temperatures used to determine the particular second rate of change of temperature.

According to the invention, the processing unit is configured to determine n-1 third correlation data points, where each third correlation data point is a correlation between each third rate of change of temperature of the n-1 third rates of change of temperature with an associated third temperature. For a particular third rate of change of temperature the associated third temperature is a first temperature of two third temperatures used to determine the particular third rate of change of temperature or is a second temperature of the two third temperatures used to determine the particular third rate of change of temperature or is an average of the first temperature and second temperature of the two third temperatures used to determine the particular third rate of change of temperature.

According to the invention, the determination of the state of the switchgear comprises utilization of the n-1 first correlation data points, the n-1 second correlation data points, and the n-1 third correlation data points.

It is to be noted that the n-1 correlations data points can be a single correlation of one temperature, and one rate of change of temperature or a time series of this data.

To put this another way, as the switchgear heats up, temperature data, for example a maximum temperature within a compartment associated with a phase of a switchgear, and the associated temperature gradient data, for a particular current flow over a time window should have a specific shape with respect to actual values of temperature (T) and temperature gradient (dT) when plotted against each other. The shape of this curve, for this current value, can then be used to determine if the switchgear is heating up normally or is heating up abnormally, and there could be a hot spot developing or higher than expected current flow and now hotspot as such caused by a fault as such (loose joint or high resistance), through for example comparison with reference shape data or utilization of shape recognition capabilities in software, for example in machine learning algorithms.

In an example, the at least one temperature sensor comprises one or more infrared cameras, and the temperature data for each location of the at least one location for each phase at the n time points is determined from one or more infrared images acquired at each of the n time points.

In an example, the at least one temperature sensor comprises a plurality of point sensors located at the at least one location of the three phases, and the temperature data for the at least one location at the n time points for each phase is acquired by one or more point sensors at each of the n time points.

In an example, the one or more locations of the at least one location of the first phase are determined as one or more locations with one or more maximum temperatures for the first phase.

In an example, the one or more locations of the at least one location of the second phase are determined as one or more locations with one or more maximum temperatures for the second phase.

In an example, the one or more locations of the at least one location of the third phase are determined as one or more locations with one or more maximum temperatures for the third phase.

In an example, the processing unit is configured to access a database of rates of change of temperature data and associated temperature data for three phases of a switchgear. The determination of the state of the switchgear can then comprise utilization of the database of rates of change of temperature data and associated temperature data.

In an example, the processing unit is configured to implement a machine learning algorithm, and the determination of the state of the switchgear comprises utilization of the machine learning algorithm. The machine learning algorithm was trained on the basis of rates of change of temperature data and associated temperature data.

According to the invention, the system comprises:
- at least three current sensors.

One or more first current sensors of the at least three current sensors are configured to acquire first electrical current data for at least one location of the first phase of the switchgear at the n time points. One or more second current sensors of the at least three current sensors are configured to acquire second electrical current data for at least one location of the second phase of the switchgear at the n time points. One or more third current sensors of the at least three current sensors are configured to acquire third electrical current data for at least one location of the third phase of the switchgear at the n time points. The at least three current sensors are configured to provide the first electrical current data, the second electrical current data, and the third electrical current data to the processing unit. The determination of the state of the switchgear comprises utilization of at least n-1 of the n first electrical current data for the one or more locations of the first phase and at least n-1 of the n second electrical current data for the one or more locations of the second phase and at least n-1 of the n third electrical current data for the one or more locations of the third phase.

Thus, temperature data for each phase is acquired, for example at consecutive time points for a location that for example exhibits a maximum temperature for each phase, is acquired to determine a rate of change of temperature for each phase at this location. At the same time points the current load for each phase is determined for that location. Then taking the case of n = 2 a single the rate of change of temperature along with one of the two temperatures and one of the two current load values for each phase, thus 9 data points, is sufficient to determine if one of the phases has a problem and a hot spot is developing due to a fault such as a lose joint or increased resistance for example in a busbar of that phase, or if overheating is occurring due to a too high current load or that phase, but where there is no physical problem with the load as such. It can be determined if there is overheating due to a fault in any phase, or increased current load in one phase, and indeed if overall overheating is occurring due to increased current for all of the phases.

In other words, temperature data for a specific location, for example that with a maximum temperature, is acquired for each phase of a three-phase system, along with rate of change temperature, or temperature gradient data, and electrical current data all as a function of time for the locations. Thus, for example, two temperatures for a location can be acquired at two consecutive time points, from which a rate of change of temperature is determined for the location. At the same time two current measurements are made at the two time points. Then one of the two temperatures, along with the rate of change of temperature and one of the current measurement values for each phase provide enough information to determine if the operation is normal or abnormal.

Here, again n can be equal to 2, but it can be 5, 10, 20 ... 500 etc. Thus, rather than singles values of temperature, rate of change of temperature, and current flow in effect at the same time point, a time series of the values can be utilized.

The manner in which all of this data changes with time is used to indicate if a problem is occurring at the location of any of the phases , for example a hot spot has developed or is in the process of developing, because this 3D data set provides a "fingerprint" that can be used to determine if the operation is normal or abnormal, and can determine if the overall switchgear is overheating due to all the loads having an abnormally high current load. The determination of normal or abnormal operation can again be made using reference data in some manner, for example via a relatively simple comparison of the acquired 3D data set with reference 3D data or a more complex utilization of a trained machine learning algorithm, such as a neural network. The determination of normal or abnormal operation can again be made by comparing the 3D data set with equivalent data for the other phases of for example a three-phase system, and indeed comparing the actual data for one phase against the acquired data for the other two phases to assess if one phase is behaving abnormally.

To put this another way, as parts of a switchgear heat up, the temperatures and rates of temperatures of parts along with the electrical current passing through those parts provide a temporally varying 3D set of data that should change in a way that can signify that there is no problem with the parts of the switchgear.

It can also be determined from this 3D data set if overheating is caused by higher than normal current flow, or for example is caused by increased resistance along a current route, where the current flow is normal.

According to the invention, each first correlation data point is a correlation between each first rate of change of temperature of the n-1 first rates of change of temperature with the associated first temperature and an associated first electrical current data. The associated first electrical current data is one of the two first electrical current data at the two time points when the two first temperature data were acquired that were used to calculate the associated first rate of change of temperature or the associated first electrical current data is an average of the two first electrical current data at the two time points when the two first temperature data were acquired that were used to calculate the associated first rate of change of temperature.

According to the invention, each second correlation data point is a correlation between each second rate of change of temperature of the n-1 second rates of change of temperature with the associated second temperature and an associated second electrical current data. The associated second electrical current data is one of the two second electrical current data at the two time points when the two second temperature data were acquired that were used to calculate the associated second rate of change of temperature or the associated second electrical current data is an average of the two second electrical current data at the two time points when the two second temperature data were acquired that were used to calculate the associated second rate of change of temperature.

According to the invention, each third correlation data point is a correlation between each third rate of change of temperature of the n-1 third rates of change of temperature with the associated third temperature and an associated third electrical current data. The associated third electrical current data is one of the two third electrical current data at the two time points when the two third temperature data were acquired that were used to calculate the associated third rate of change of temperature or the associated third electrical current data is an average of the two third electrical current data at the two time points when the two third temperature data were acquired that were used to calculate the associated third rate of change of temperature.

Thus, now the individual correlation data points are a correlation between each rate of change of temperature of the n-1 rates of change of temperature with an associated temperature and an associated electrical current measurement, where the electrical current measurement is one of the two electrical current measurements at the time points when the first temperature and second temperature was acquired that was used to calculate the rate of change of temperature, and wherein the determination of the state of the switchgear comprises utilization of the n-1 correlation data points that now include the electrical current data correlated with temperature and rate of change of temperature data, which can again be a single correlation of one temperature, one rate of change of temperature and one electrical current measurement or a time series of this data for each phase.

To put this another way, as the switchgear heats up, temperature data, for example a maximum temperature within a compartment associated with each phase of a switchgear, and the associated temperature gradient data, for a particular current flow over a time window should have a specific shape with respect to actual values of temperature (T) and temperature gradient (dT) when plotted against each other. The shape of this curve, for this current value, can then be used to determine if the switchgear is heating up normally or is heating up abnormally, and there could be a hot spot developing or higher than expected current flow and now hotspot as such caused by a fault as such (loose joint or high resistance), through for example comparison with reference shape data or utilization of shape recognition capabilities in software, for example in machine learning algorithms.

However, the 9 data points in terms of rate of change of temperature with one of the two temperatures used in determining the rate of change of temperature and the current load for each phase, for example at a location with a maximum temperature for each phase (i.e. when n =2) is enough to characterize if a phase has a problem in terms of overheating, and the cause (fault or current load for a phase), and whether the whole switchgear is overheating due to increased current load for all the phases.

In an example, the processing unit is configured to access a database of rates of change of temperature data and associated temperature data and associated electrical current data for three phases of a switchgear. The determination of the state of the switchgear can then comprise utilization of the database of rates of change of temperature data and associated temperature data and associated electrical current data.

In an example, the determination of the state of the switchgear comprises a comparison of the n-1 first rates of change of temperature for the one or more locations of the first phase and the at least n-1 of the n first temperature data for the one or more locations of the first phase and the at least n-1 of the n first electrical current data for the one or more locations of the first phase with the database of rates of change of temperature data and associated temperature data and associated electrical current data.

In an example, the determination of the state of the switchgear comprises a comparison of the n-1 second rates of change of temperature for the one or more locations of the second phase and the at least n-1 of the n second temperature data for the one or more locations of the second phase and the at least n-1 of the n second electrical current data for the one or more locations of the second phase with the database of rates of change of temperature data and associated temperature data and associated electrical current data.

In an example, the determination of the state of the switchgear comprises a comparison of the n-1 third rates of change of temperature for the one or more locations of the third phase and the at least n-1 of the n third temperature data for the one or more locations of the third phase and the at least n-1 of the n third electrical current data for the one or more locations of the third phase with the database of rates of change of temperature data and associated temperature data and associated electrical current data.

In an example, the database of rates of change of temperature and associated temperature data and associated electrical current data comprises data for the at least one location of the switchgear or an equivalent switchgear.

In an example, the processing unit is configured to implement a machine learning algorithm. The determination of the state of the switchgear can then comprise utilization of the machine learning algorithm, and the machine learning algorithm was trained on the basis of rates of change of temperature data and associated temperature data and associated electrical current data.

In an embodiment, there is provided a switchgear comprising a system according to the first aspect.

In a second aspect, there is provided a method for monitoring a three phase switchgear, the method comprising:
- acquiring by one or more of at least one temperature sensor first temperature data for each location of at least one location of a first phase of a switchgear at n time points;
- acquiring by one or more of the at least one temperature sensor second temperature data for each location of at least one location of a second phase of the switchgear at the n time points;
- acquiring by one or more of the at least one temperature sensor third temperature data for each location of at least one location of a third phase of the switchgear at the n time points;
- acquiring by one or more first current sensors of at least three current sensors first electrical current data for at least one location of the first phase of the switchgear at the n time points;-acquiring by one or more second current sensors of the at least three current sensors second electrical current data for at least one location of the second phase of the switchgear at the n time points;- acquiring by one or more third current sensors of the at least three current sensors third electrical current data for at least one location of the third phase of the switchgear at the n time points;
- providing by the at least one temperature sensor the first temperature data, the second temperature data, and the third temperature data to a processing unit;
- providing by the at least three current sensors the first electrical current data, the second electrical current data, and the third electrical current data to a processing unit;
- determining by the processing unit n-1 first rates of change of temperature for one or more locations of the at least one location of the first phase with respect to the n first temperature data for the one or more locations of the first phase at the n time points;
- determining by the processing unit n-1 second rates of change of temperature for one or more locations of the at least one location of the second phase with respect to the n second temperature data for the one or more locations of the second phase at the n time points;
- determining by the processing unit n-1 third rates of change of temperature for one or more locations of the at least one location of the third phase with respect to the n third temperature data for the one or more locations of the third phase at the n time points; determining by the processing unit n-1 first correlation data points, wherein each first correlation data point is a correlation between each first rate of change of temperature of the n-1 first rates of change of temperature with an associated first temperature and an associated first electrical current data, wherein the associated first electrical current data is one of the two first electrical current data at the two time points when the two first temperature data were acquired that were used to calculate the associated first rate of change of temperature or the associated first electrical current data is an average of the two first electrical current data at the two time points when the two first temperature data were acquired that were used to calculate the associated first rate of change of temperature, wherein for a particular first rate of change of temperature the associated first temperature is a first temperature of two first temperatures used to determine the particular first rate of change of temperature or is a second temperature of the two first temperatures used to determine the particular first rate of change of temperature or is an average of the first temperature and second temperature of the two first temperatures used to determine the particular first rate of change of temperature;determining by the processing unit n-1 second correlation data points, wherein each second correlation data point is a correlation between each second rate of change of temperature of the n-1 second rates of change of temperature with an associated second temperature and an associated second electrical current data, wherein the associated second electrical current data is one of the two second electrical current data at the two time points when the two second temperature data were acquired that were used to calculate the associated second rate of change of temperature or the associated second electrical current data is an average of the two second electrical current data at the two time points when the two second temperature data were acquired that were used to calculate the associated second rate of change of temperature , wherein for a particular second rate of change of temperature the associated second temperature is a first temperature of two second temperatures used to determine the particular second rate of change of temperature or is a second temperature of the two second temperatures used to determine the particular second rate of change of temperature or is an average of the first temperature and second temperature of the two second temperatures used to determine the particular second rate of change of temperature;determining by the processing unit n-1 third correlation data points, wherein each third correlation data point is a correlation between each third rate of change of temperature of the n-1 third rates of change of temperature with an associated third temperature and an associated third electrical current data, wherein the associated third electrical current data is one of the two third electrical current data at the two time points when the two third temperature data were acquired that were used to calculate the associated third rate of change of temperature or the associated third electrical current data is an average of the two third electrical current data at the two time points when the two third temperature data were acquired that were used to calculate the associated third rate of change of temperature, wherein for a particular third rate of change of temperature the associated third temperature is a first temperature of two third temperatures used to determine the particular third rate of change of temperature or is a second temperature of the two third temperatures used to determine the particular third rate of change of temperature or is an average of the first temperature and second temperature of the two third temperatures used to determine the particular third rate of change of temperature;
- determining by the processing unit a state of the switchgear, wherein the determination of the state of the switchgear comprises utilization of the n-1 first rates of change of temperature for the one or more locations of the first phase and at least n-1 of the n first temperature data for the one or more locations of the first phase and the n-1 second rates of change of temperature for the one or more locations of the second phase and at least n-1 of the n second temperature data for the one or more locations of the second phase and the n-1 third rates of change of temperature for the one or more locations of the third phase and at least n-1 of the n third temperature data for the one or more locations of the third phase and at least n-1 of the n first electrical current data for the one or more locations of the first phase and at least n-1 of the n second electrical current data for the one or more locations of the second phase and at least n-1 of the n third electrical current data for the one or more locations of the third phase and the n-1 first correlation data points and the n-1 second correlation data points and the n-1 third correlation data points; and
- outputting by an output unit the determined state of the switchgear when the determined state of the switchgear is determined not to be normal or not to be healthy.

Here, n can be equal to 2, but it can be 5, 10, 20 ... 500 etc. Thus, rather than single values of temperature, and rate of change of temperature, in effect at the same time point for each phase being utilized, a time series of the temperature values and rates of change of temperature values can be utilized.

According to another aspect, there is provided a computer program element controlling one or more of the systems as previously described which, if the computer program element is executed by a processor, is adapted to perform the methods as previously described.

In an example, there could be provided a computer readable medium having stored a computer element as previously described.

The computer program element can for example be a software program but can also be a FPGA, a PLD or any other appropriate digital means.

The above aspects and examples will become apparent from and be elucidated with reference to the embodiments described hereinafter.

### BRIEF DESCRIPTION OF THE DRAWINGS

Exemplary embodiments will be described in the following with reference to the following drawings:
Fig. 1 shows a schematic example of a system for monitoring a switchgear;
Fig. 2 shows a schematic example of a method for monitoring a switchgear;
Fig. 3 shows a plot of temperature data on the x axis with associate rate of change of temperature (temperature gradient data) for both healthy and unhealthy situations;
Fig. 4 shows plots of temperature data on the x axis with associate rate of change of temperature (temperature gradient data) for all three phases of a three phase switchgear; and
Fig. 5 shows a schematic example of a workflow of an embodiment a system/method for monitoring a switchgear.

### DETAILED DESCRIPTION OF EMBODIMENTS

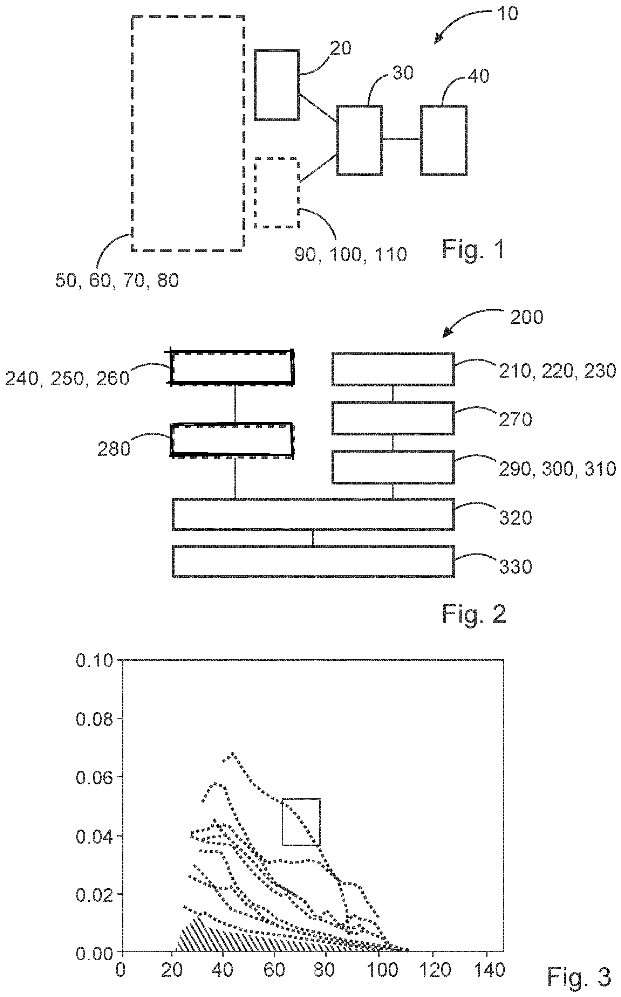

Fig. 1 shows an example of a system 10 for monitoring a three phase switchgear. The system 10 comprises:
- at least one temperature sensor 20;
- a processing unit 30; and
- an output unit 40.

One or more of the at least one temperature sensor is configured to acquire first temperature data for each location of at least one location of a first phase 50 of a switchgear 80 at n time points. One or more of the at least one temperature sensor is configured to acquire second temperature data for each location of at least one location of a second phase 60 of the switchgear at the n time points. One or more of the at least one temperature sensor is configured to acquire third temperature data for each location of at least one location of a third phase 70 of the switchgear at the n time points. n is an integer that for example can be 2, 5, 10, 20, 50, 100, 200, 500, 1000, 2000, 5000 or a number greater than 5000 and a number between any of the number here listed. The switchgear is shown as a dotted box in Fig. 1 because it is not part of the system as such, where for example the system could be retrofitted to a switchgear or a switchgear could in effect be manufactured with such a system. Also shown in Fig 1 as a dotted box are electrical current sensors 90, 100 and 100 that are essential to the system, where these are discussed below with respect to other embodiments. The at least one temperature sensor is configured to provide the first temperature data, the second temperature data, and the third temperature data to the processing unit. The processing unit is configured to determine n-1 first rates of change of temperature for one or more locations of the at least one location of the first phase with respect to the n first temperature data for the one or more locations of the first phase at the n time points. The processing unit is configured to determine n-1 second rates of change of temperature for one or more locations of the at least one location of the second phase with respect to the n second temperature data for the one or more locations of the second phase at the n time points. The processing unit is configured to determine n-1 third rates of change of temperature for one or more locations of the at least one location of the third phase with respect to the n third temperature data for the one or more locations of the third phase at the n time points. Rates of change in temperature are determined for example from adjacent (thus consecutive) temperature data points in time. The processing unit is configured to determine a state of the switchgear. The determination of the state of the switchgear comprises utilization of the n-1 first rates of change of temperature for the one or more locations of the first phase and at least n-1 of the n first temperature data for the one or more locations of the first phase and the n-1 second rates of change of temperature for the one or more locations of the second phase and at least n-1 of the n second temperature data for the one or more locations of the second phase and the n-1 third rates of change of temperature for the one or more locations of the third phase and at least n-1 of the n third temperature data for the one or more locations of the third phase. The output unit is configured to output the determined state of the switchgear when the determined state of the switchgear is determined not to be normal or not to be healthy.

Thus, temperature data for a specific location, for example that with a maximum temperature of for example a phase of a three-phase system, is acquired along with rate of change temperature, or temperature gradient data, as a function of time for the location of the first phase. Thus, for example, two temperatures for a location of the first phase (e.g. that is determined to have a maximum temperature for the first phase) can be acquired at two consecutive time points, from which a rate of change of temperature is determined for the location of the first phase. Then one of the two temperatures, along with the rate of change of temperature is used for further processing. Similar, for both the second and third phases, temperature data at the two consecutive time points is acquired, again for example for a locations of these phases that has a maximum temperature, and a rate of change of temperature for each phase is determined. Then again, one of the two temperatures for each phase and the rate of change of temperature is used for further processing. There is then a dataset of 6 points, a temperature and a rate of change of temperature, associated with for example a location of a maximum temperature for each phase, and these 6 data points are sufficient to characterize if the operation of one of the phases is abnormal, for example where overheating due to hot spot developing as a consequence of a loose joint of other increased resistance, or it can be determined that all the phases exhibit overheating, for example due to a higher than normal electrical current load.

Here, n can equal to 2, but it can be 5, 10, 20 ... 500 etc. Thus, rather than single values of temperature, and rate of change of temperature, in effect at the same time point for each phase being utilized, a time series of the temperature values and rates of change of temperature values can be utilized.

Thus, temperature data for a specific location, for example that with a maximum temperature of each phase of a three-phase system, is acquired along with rate of change temperature, or temperature gradient data, and analysed to determine if there is a fault or if the operation is healthy or normal. There can be data in effect at only one time point, thus 2 data points for each phase analysed, one temperature and one rate of change of temperature for each phase (where the rate of change of temperature was determined from two temperatures acquired at different time at the "time point").

At one level a simple comparison of the temperature data and associated rate of change of temperature ( 2 data points as discussed above) with the same data for the other two phases can show that one of the phases is behaving abnormally and that a hot spot is developing.

However, the manner in which all of this data changes with time is used to indicate if a problem is occurring at the location, for example a hot spot has developed or is in the process of developing, because this 3D data set provides a "fingerprint" that can be used to determine if the operation is normal or abnormal. The determination of normal or abnormal operation can be made using reference data in some manner, for example via a relatively simple comparison of the acquired 3D data set with reference 3D data or a more complex utilization of a trained machine learning algorithm, such as a neural network.

The determination of normal or abnormal operation with respect to a phase of the switch gear can also be made by comparing the 3D data set for this phase and the other phases with equivalent data for phases of for example a reference three-phase system.

The determination of normal or abnormal operation with respect to a phase of the switch gear can also be made by comparing the 3D data set for this phase against the equivalent data for the other phases.

To put this another way, as phases of a switchgear heat up, the temperatures and rates of temperatures of phases provide a temporally varying 3D set of data that should change in a way that can signify that there is no problem with the parts of the switchgear, and likewise indicate when there is a problem.

It is to be noted that a single infrared camera could be monitoring all three phases in a compartment, and two images (that could be consecutive images) and used to identified and determine temperatures at locations at each of the three phases (for example a maximum temperature for each phase) and a rate of change of temperature is determined for the location for each phase. However, three infrared cameras could be used, where each camera is monitoring a different phase. However, each phase could have an array of temperature sensors (point sensors) arranged at different locations, and one of these point sensors per phase (for example at a maximum temperature location for a phase) can be used to determine two temperature values (for example consecutive values) from which a rate of change of temperature is determined for each phase at this location.

Thus, the one or more temperature sensors that acquire the first temperature data at different locations of the first phase can be a single sensor (IR camera).

Thus, the one or more temperature sensors that acquire the second temperature data at different locations of the second phase can be a single sensor (IR camera).

Thus, the one or more temperature sensors that acquire the third temperature data at different locations of the third phase can be a single sensor (IR camera).

The same IR camera can acquire all of the this temperature data, or different IR cameras can acquire temperature data for each phase at different locations.

However, each phase can have one or more different points sensors that acquire temperature data at one or more different locations. Thus, for example each phase can have a plurality of point temperature sensors (such as thermocouples) located at different locations of the phase.

According to the invention, the output unit is configured to output the determined state of the switchgear when the determined state of the switchgear is determined to be normal or to be healthy.

In an example, the determined state of the switchgear comprises an indication that overheating is occurring.

In an example, the determined state of the switchgear comprises an indication that overheating will occur.

In an example, the determined state of the switchgear comprises an indication that overheating is occurring due to high current flow.

In an example, the determined state of the switchgear comprises an indication that overheating is occurring due to a component failure.

In an example, the component failure can be indicated as increased resistance and/or joint failure, for example based on the location of a maximum temperature.

In an example, the determined state of the switchgear comprises an indication of a fault in one of the three phases.

In an example, the determined state of the switchgear comprises an indication of an increased current load in one of the three phases.

In an example, the determined state of the switchgear comprises an indication of a location of the one or more locations for one of the phases.

According to the invention, the determination of the state of the switchgear comprises utilization of the n first temperature data for the one or more locations of the first phase, the n second temperature data for the one or more locations of the second phase, and the n third temperature data for the one or more locations of the third phase.

In other words, n temperature data points, can be used to determine n-1 temperature gradients or rates of change of temperature for example by considering consecutive pairs of temperature data points, and the n-1 temperature gradient points and the n-1 temperature points can be used to determine the state of the switchgear, however all of the temperature data points can be directly used.

In an example, the one or more of the at least one temperature sensor is configured to acquire first temperature data for each location of the at least one location of the first phase at m time points, where m is greater than n, and the n time points are consecutive time points of the m time points.

In an example, the one or more of the at least one temperature sensor is configured to acquire second temperature data for each location of the at least one location of the second phase at the m time points, where m is greater than n, and where the n time points are consecutive time points of the m time points.

In an example, the one or more of the at least one temperature sensor is configured to acquire third temperature data for each location of the at least one location of the third phase at the m time points, wherein m is greater than n, and where the n time points are consecutive time points of the m time points.

In other words, the system can in effect be acquiring temperature data in real time at time steps, and temperature gradient or rate of change of temperatures are determined for each temperature data point as it is acquired, for example via a comparison with the previously acquired temperature point for that location. Then a time window of n data points of temperature data yields n-1 temperature gradient points, and these temperature gradient points can be analysed along with n-1 (or indeed all of the n temperature data points) to determine a state of the switchgear, and this is done for each phase with respect to a location of each phase, that could for example be the location that has the maximum temperature for that phase.

In an example, each of the n-1 first rates of change of temperature are determined for consecutive temperature data of the n first temperature data for the one or more locations of the first phase.

In an example, each of the n-1 second rates of change of temperature are determined for consecutive temperature data of the n second temperature data for the one or more locations of the second phase.

In an example, each of the n-1 third rates of change of temperature are determined for consecutive temperature data of the n third temperature data for the one or more locations of the third phase.

According to the invention, the processing unit is configured to determine n-1 first correlation data points, where each first correlation data point is a correlation between each first rate of change of temperature of the n-1 first rates of change of temperature with an associated first temperature. For a particular first rate of change of temperature the associated first temperature is a first temperature of two first temperatures used to determine the particular first rate of change of temperature or is a second temperature of the two first temperatures used to determine the particular first rate of change of temperature or is an average of the first temperature and second temperature of the two first temperatures used to determine the particular first rate of change of temperature.

According to the invention, the processing unit is configured to determine n-1 second correlation data points, where each second correlation data point is a correlation between each second rate of change of temperature of the n-1 second rates of change of temperature with an associated second temperature. For a particular second rate of change of temperature the associated second temperature is a first temperature of two second temperatures used to determine the particular second rate of change of temperature or is a second temperature of the two second temperatures used to determine the particular second rate of change of temperature or is an average of the first temperature and second temperature of the two second temperatures used to determine the particular second rate of change of temperature.

According to the invention, the processing unit is configured to determine n-1 third correlation data points, where each third correlation data point is a correlation between each third rate of change of temperature of the n-1 third rates of change of temperature with an associated third temperature. For a particular third rate of change of temperature the associated third temperature is a first temperature of two third temperatures used to determine the particular third rate of change of temperature or is a second temperature of the two third temperatures used to determine the particular third rate of change of temperature or is an average of the first temperature and second temperature of the two third temperatures used to determine the particular third rate of change of temperature.

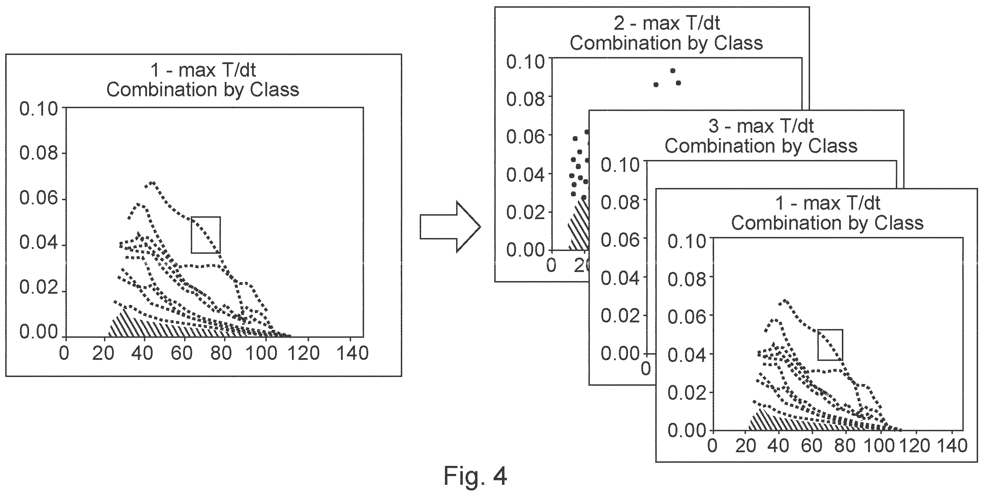

The correlation of temperature against rate of temperature (pairs) is shown in Fig. 3 for one phase and in Fig. 4 for all three phases.

According to the invention, the determination of the state of the switchgear comprises utilization of the n-1 first correlation data points, the n-1 second correlation data points, and the n-1 third correlation data points.

It is to be noted that the n-1 correlations data points can be a single correlation of one temperature, and one rate of change of temperature or a time series of this data.

To put this another way, as the switchgear heats up, temperature data, for example a maximum temperature within a compartment associated with a phase of a switchgear, and the associated temperature gradient data, for a particular current flow over a time window should have a specific shape with respect to actual values of temperature (T) and temperature gradient (dT) when plotted against each other. The shape of this curve, for this current value, can then be used to determine if the switchgear is heating up normally or is heating up abnormally, and there could be a hot spot developing or higher than expected current flow and now hotspot as such caused by a fault as such (loose joint or high resistance), through for example comparison with reference shape data or utilization of shape recognition capabilities in software, for example in machine learning algorithms.

In an example, the determination of the state of the switchgear comprises utilization of a shape of the n-1 correlation data points.

In an example, the at least one temperature sensor comprises one or more infrared cameras, and the temperature data for each location of the at least one location for each phase at the n time points is determined from one or more infrared images acquired at each of the n time points.

In an example, the at least one temperature sensor is a single infrared camera.

In an example, the at least one temperature sensor is three infrared cameras, one or for phase.

In an example, the at least one temperature sensor comprises a plurality of point sensors located at the at least one location of the three phases, and the temperature data for the at least one location at the n time points for each phase is acquired by one or more point sensors at each of the n time points. Such point sensors can for example be thermocouples.

In an example, the one or more locations of the at least one location of the first phase are determined as one or more locations with one or more maximum temperatures for the first phase.

In an example, the one or more locations of the at least one location of the second phase are determined as one or more locations with one or more maximum temperatures for the second phase.

In an example, the one or more locations of the at least one location of the third phase are determined as one or more locations with one or more maximum temperatures for the third phase.

Thus, temperature data at a plurality of locations of each phase can be acquired, but the processing unit analyses the temperature data at the location that has a maximum temperature for each phase, because this is where it is most likely that a hot spot is to be found here if one is developing.

In an example, the processing unit is configured to access a database of rates of change of temperature data and associated temperature data for three phases of a switchgear. The determination of the state of the switchgear can then comprise utilization of the database of rates of change of temperature data and associated temperature data.

In an example, the determination of the state of the switchgear comprises a comparison of the n-1 first rates of change of temperature for the one or more locations of the first phase and the at least n-1 of the n first temperature data for the one or more locations of the first phase with the database of rates of change of temperature data and associated temperature data.

In an example, the determination of the state of the switchgear comprises a comparison of the n-1 second rates of change of temperature for the one or more locations of the second phase and the at least n-1 of the n second temperature data for the one or more locations of the second phase with the database of rates of change of temperature data and associated temperature data.

In an example, the determination of the state of the switchgear comprises a comparison of the n-1 third rates of change of temperature for the one or more locations of the third phase and the at least n-1 of the n third temperature data for the one or more locations of the third phase with the database of rates of change of temperature data and associated temperature data.

In an example, the database of rates of change of temperature and associated temperature data comprises data for the at least one location of the switchgear or an equivalent switchgear.

In an example, the database of rates of change of temperature and associated temperature data comprises data at a plurality of time points.

In an example, the processing unit is configured to implement a machine learning algorithm. The determination of the state of the switchgear comprises utilization of the machine learning algorithm, and the machine learning algorithm was trained on the basis of rates of change of temperature data and associated temperature data.

Thus, the machine learning algorithm such as a neural network is trained on rates of change of temperature data and associated temperature data for three phases of a switchgear the same as the switchgear being monitored, where the training data can be for many different modes of operation, including operation where failures in terms of loose joints are simulated and where situations of abnormally high current load are use to obtain training data. The training data can be data for in effect single data points in time, and/or data points that constitute time series of temperature and rate of change of temperature data.

In an example, the rates of change of temperature and associated temperature data used to train the machine leaning algorithm comprises data for the at least one location of each phase of the switchgear or an equivalent switchgear.

In an example, the rates of change of temperature and associated temperature data used to train the machine learning algorithm comprises data at a plurality of time points.

Fig. 1 shows a development, with respect to current sensors 90, 100, and 110 shown as a dashed box. Thus, in an example, the system comprises:
- at least three current sensors 90, 100, 110.

One or more first current sensors 90 of the at least three current sensors are configured to acquire first electrical current data for at least one location of the first phase of the switchgear at the n time points. One or more second current sensors 100 of the at least three current sensors are configured to acquire second electrical current data for at least one location of the second phase of the switchgear at the n time points. One or more third current sensors 110 of the at least three current sensors are configured to acquire third electrical current data for at least one location of the third phase of the switchgear at the n time points. The at least three current sensors are configured to provide the first electrical current data, the second electrical current data, and the third electrical current data to the processing unit. The determination of the state of the switchgear comprises utilization of at least n-1 of the n first electrical current data for the one or more locations of the first phase and at least n-1 of the n second electrical current data for the one or more locations of the second phase and at least n-1 of the n third electrical current data for the one or more locations of the third phase.

Thus, temperature data for each phase is acquired, for example at consecutive time points for a location that for example exhibits a maximum temperature for each phase, is acquired to determine a rate of change of temperature for each phase at this location. At the same time points the current load for each phase is determined for that location. Then taking the case of n = 2 a single the rate of change of temperature along with one of the two temperatures and one of the two current load values for each phase, thus 9 data points, is sufficient to determine if one of the phases has a problem and a hot spot is developing due to a fault such as a lose joint or increased resistance for example in a busbar of that phase, or if overheating is occurring due to a too high current load or that phase, but where there is no physical problem with the load as such. It can be determined if there is overheating due to a fault in any phase, or increased current load in one phase, and indeed if overall overheating is occurring due to increased current for all of the phases.

In other words, temperature data for a specific location, for example that with a maximum temperature, is acquired for each phase of a three-phase system, along with rate of change temperature, or temperature gradient data, and electrical current data all as a function of time for the locations. Thus, for example, two temperatures for a location can be acquired at two consecutive time points, from which a rate of change of temperature is determined for the location. At the same time two current measurements are made at the two time points. Then one of the two temperatures, along with the rate of change of temperature and one of the current measurement values for each phase provide enough information to determine if the operation is normal or abnormal.

Here, again n can be equal to 2, but it can be 5, 10, 20 ... 500 etc. Thus, rather than singles values of temperature, rate of change of temperature, and current flow in effect at the same time point, a time series of the values can be utilized.

The manner in which all of this data changes with time is used to indicate if a problem is occurring at the location of any of the phases , for example a hot spot has developed or is in the process of developing, because this 3D data set provides a "fingerprint" that can be used to determine if the operation is normal or abnormal, and can determine if the overall switchgear is overheating due to all the loads having an abnormally high current load. The determination of normal or abnormal operation can again be made using reference data in some manner, for example via a relatively simple comparison of the acquired 3D data set with reference 3D data or a more complex utilization of a trained machine learning algorithm, such as a neural network. The determination of normal or abnormal operation can again be made by comparing the 3D data set with equivalent data for the other phases of for example a three-phase system, and indeed comparing the actual data for one phase against the acquired data for the other two phases to assess if one phase is behaving abnormally.

To put this another way, as parts of a switchgear heat up, the temperatures and rates of temperatures of parts along with the electrical current passing through those parts provide a temporally varying 3D set of data that should change in a way that can signify that there is no problem with the parts of the switchgear.

It can also be determined from this 3D data set if overheating is caused by higher than normal current flow, or for example is caused by increased resistance along a current route, where the current flow is normal.

According to the invention, the determination of the state of the switchgear comprises utilization of the n-1 rates of change of temperature for the one or more locations and the n temperature data for the one or more locations at the n time points and the n electrical current data for the one or more locations at the n time points.

In an example, each current sensor is configured to acquire electrical data for the at least one location of the switchgear at m time points, wherein m is greater than n, and wherein the n time points are consecutive time points of the m time points.

In other words, the system can in effect be acquiring temperature data and electrical current data in real time at time steps for each phase, and temperature gradient or rate of change of temperatures are determined for each temperature data point as it is acquired, for example via a comparison with the previously acquired temperature point for that location. Then a time window of n data points of temperature data and electrical current data yields n-1 temperature gradient points (that can be just one temperature value, one temperature gradient value and one electrical current value or a time series of these values) for each phase, and one temperature value, one temperature gradient value and one electrical current value, or a time series of these values, for each phase is analyzed (thus, 9, 18, 27, 36 or any multiple of 9 as n increases) to determine a state of the switchgear.

According to the invention, each first correlation data point is a correlation between each first rate of change of temperature of the n-1 first rates of change of temperature with the associated first temperature and an associated first electrical current data. The associated first electrical current data is one of the two first electrical current data at the two time points when the two first temperature data were acquired that were used to calculate the associated first rate of change of temperature or the associated first electrical current data is an average of the two first electrical current data at the two time points when the two first temperature data were acquired that were used to calculate the associated first rate of change of temperature.

According to the invention, each second correlation data point is a correlation between each second rate of change of temperature of the n-1 second rates of change of temperature with the associated second temperature and an associated second electrical current data. The associated second electrical current data is one of the two second electrical current data at the two time points when the two second temperature data were acquired that were used to calculate the associated second rate of change of temperature or the associated second electrical current data is an average of the two second electrical current data at the two time points when the two second temperature data were acquired that were used to calculate the associated second rate of change of temperature.

According to the invention, each third correlation data point is a correlation between each third rate of change of temperature of the n-1 third rates of change of temperature with the associated third temperature and an associated third electrical current data. The associated third electrical current data is one of the two third electrical current data at the two time points when the two third temperature data were acquired that were used to calculate the associated third rate of change of temperature or the associated third electrical current data is an average of the two third electrical current data at the two time points when the two third temperature data were acquired that were used to calculate the associated third rate of change of temperature.

Thus, now the individual correlation data points are a correlation between each rate of change of temperature of the n-1 rates of change of temperature with an associated temperature and an associated electrical current measurement, where the electrical current measurement is one of the two electrical current measurements at the time points when the first temperature and second temperature was acquired that was used to calculate the rate of change of temperature, and wherein the determination of the state of the switchgear comprises utilization of the n-1 correlation data points that now include the electrical current data correlated with temperature and rate of change of temperature data, which can again be a single correlation of one temperature, one rate of change of temperature and one electrical current measurement or a time series of this data for each phase.

To put this another way, as the switchgear heats up, temperature data, for example a maximum temperature within a compartment associated with each phase of a switchgear, and the associated temperature gradient data, for a particular current flow over a time window should have a specific shape with respect to actual values of temperature (T) and temperature gradient (dT) when plotted against each other. The shape of this curve, for this current value, can then be used to determine if the switchgear is heating up normally or is heating up abnormally, and there could be a hot spot developing or higher than expected current flow and now hotspot as such caused by a fault as such (loose joint or high resistance), through for example comparison with reference shape data or utilization of shape recognition capabilities in software, for example in machine learning algorithms.

However, the 9 data points in terms of rate of change of temperature with one of the two temperatures used in determining the rate of change of temperature and the current load for each phase, for example at a location with a maximum temperature for each phase (i.e. when n =2) is enough to characterize if a phase has a problem in terms of overheating, and the cause (fault or current load for a phase), and whether the whole switchgear is overheating due to increased current load for all the phases.

According to the invention, the determination of the state of the switchgear comprises utilization of a shape of the n-1 correlation data points for each phase.

Thus, when a time series of data are acquired over a time window, for example 6 consecutive temperature data points for a location of a maximum temperature for a phase, 5 rate of change of temperature values can be determined for this location and at the same time 6 consecutive electrical current data measurements can be made for this location. Then 5 of the temperature data, the 5 rate of change of temperature data values and the 5 electrical current data values provide a time window series of data that characterize the phase over a time window. The equivalent data is acquired for the other two phases. Then if currents do not change then there are three curves one for each phase that characterize the switchgear, and if current for the phase change over the time window then there are three surfaces that characterize the switchgear.

According to the invention, the output unit is configured to output the determined state of the switchgear when the determined state of the switchgear is determined to be normal or to be healthy.

In an example, the determined state of the switchgear comprises an indication that overheating is occurring.

In an example, the determined state of the switchgear comprises an indication that overheating will occur.

In an example, the determined state of the switchgear comprises an indication that overheating is occurring due to high current flow.

In an example, the determined state of the switchgear comprises an indication that overheating is occurring due to a component failure.

In an example, the component failure can be indicated as increased resistance and/or joint failure, for example based on the location of a maximum temperature.

In an example, the determined state of the switchgear comprises an indication of a fault in one of the three phases.

In an example, the determined state of the switchgear comprises an indication of an increased current load in one of the three phases.

In an example, the determined state of the switchgear comprises an indication of a location of the one or more locations.

In an example, the processing unit is configured to access a database of rates of change of temperature data and associated temperature data and associated electrical current data for three phases of a switchgear. The determination of the state of the switchgear can then comprise utilization of the database of rates of change of temperature data and associated temperature data and associated electrical current data.

In an example, the determination of the state of the switchgear comprises a comparison of the n-1 first rates of change of temperature for the one or more locations of the first phase and the at least n-1 of the n first temperature data for the one or more locations of the first phase and the at least n-1 of the n first electrical current data for the one or more locations of the first phase with the database of rates of change of temperature data and associated temperature data and associated electrical current data.

In an example, the determination of the state of the switchgear comprises a comparison of the n-1 second rates of change of temperature for the one or more locations of the second phase and the at least n-1 of the n second temperature data for the one or more locations of the second phase and the at least n-1 of the n second electrical current data for the one or more locations of the second phase with the database of rates of change of temperature data and associated temperature data and associated electrical current data.

In an example, the determination of the state of the switchgear comprises a comparison of the n-1 third rates of change of temperature for the one or more locations of the third phase and the at least n-1 of the n third temperature data for the one or more locations of the third phase and the at least n-1 of the n third electrical current data for the one or more locations of the third phase with the database of rates of change of temperature data and associated temperature data and associated electrical current data.

In an example, the database of rates of change of temperature and associated temperature data and associated electrical current data comprises data for the at least one location of the switchgear or an equivalent switchgear.

In an example, the database of rates of change of temperature and associated temperature data and associated electrical current data comprises data at a plurality of time points.

In an example, the processing unit is configured to implement a machine learning algorithm. The determination of the state of the switchgear comprises utilization of the machine learning algorithm, and the machine learning algorithm was trained on the basis of rates of change of temperature data and associated temperature data and associated electrical current data.

The machine learning algorithm is similar to that described previously, but where now it is also trained with electrical current data for locations of the three phases where the temperature data is acquired. It is to be note that a single current load can be flowing through a phase, and therefore one current sensor can be utilized to determine the current everywhere. However, with respect to possible switching behaviour of the phase more than one current sensor can be utilized to determine the current load in different parts of a phase.

In an example, the rates of change of temperature and associated temperature data and associated electrical current data used to train the machine leaning algorithm comprises data for the at least one location of each phase of the switchgear or an equivalent switchgear

In an example, the rates of change of temperature and associated temperature data and associated electrical current data used to train the machine learning algorithm comprises data at a plurality of time points.

As made clear from the above discussion a switchgear 80 can comprise a system 10 as described above with respect to Fig. 1.

Fig. 2 shows a method 200 for monitoring a three phase switchgear. The method 200 in its basic steps is shown with respect to the solid boxes, other optional steps are also discussed below. The method 200 in its basic step comprises:
- acquiring 210 by one or more of at least one temperature sensor first temperature data for each location of at least one location of a first phase of a switchgear at n time points;
- acquiring 220 by one or more of the at least one temperature sensor second temperature data for each location of at least one location of a second phase of the switchgear at the n time points;
- acquiring 230 by one or more of the at least one temperature sensor third temperature data for each location of at least one location of a third phase of the switchgear at the n time points;
- providing 270 by the at least one temperature sensor the first temperature data, the second temperature data, and the third temperature data to a processing unit;
- determining 290 by the processing unit n-1 first rates of change of temperature for one or more locations of the at least one location of the first phase with respect to the n first temperature data for the one or more locations of the first phase at the n time points;
- determining 300 by the processing unit n-1 second rates of change of temperature for one or more locations of the at least one location of the second phase with respect to the n second temperature data for the one or more locations of the second phase at the n time points;
- determining 310 by the processing unit n-1 third rates of change of temperature for one or more locations of the at least one location of the third phase with respect to the n third temperature data for the one or more locations of the third phase at the n time points;
- determining 320 by the processing unit a state of the switchgear, wherein the determination of the state of the switchgear comprises utilization of the n-1 first rates of change of temperature for the one or more locations of the first phase and at least n-1 of the n first temperature data for the one or more locations of the first phase and the n-1 second rates of change of temperature for the one or more locations of the second phase and at least n-1 of the n second temperature data for the one or more locations of the second phase and the n-1 third rates of change of temperature for the one or more locations of the third phase and at least n-1 of the n third temperature data for the one or more locations of the third phase; and
- outputting 330 by an output unit the determined state of the switchgear when the determined state of the switchgear is determined not to be normal or not to be healthy.

Here, n can be equal to 2, but it can be 5, 10, 20 ... 500 etc. Thus, rather than single values of temperature, and rate of change of temperature, in effect at the same time point for each phase being utilized, a time series of the temperature values and rates of change of temperature values can be utilized.

According to the invention, the output unit is configured to output the determined state of the switchgear when the determined state of the switchgear is determined to be normal or to be healthy.

In an example, the determined state of the switchgear comprises an indication that overheating is occurring.

In an example, the determined state of the switchgear comprises an indication that overheating will occur.

In an example, the determined state of the switchgear comprises an indication that overheating is occurring due to high current flow.

In an example, the determined state of the switchgear comprises an indication that overheating is occurring due to a component failure.

In an example, the component failure can be indicated as increased resistance and/or joint failure, for example based on the location of a maximum temperature.

In an example, the determined state of the switchgear comprises an indication of a fault in one of the three phases.

In an example, the determined state of the switchgear comprises an indication of an increased current load in one of the three phases.

In an example, the determined state of the switchgear comprises an indication of a location of the one or more locations for one of the phases.

According to the invention, the determination of the state of the switchgear comprises utilization of the n first temperature data for the one or more locations of the first phase, the n second temperature data for the one or more locations of the second phase, and the n third temperature data for the one or more locations of the third phase .

According to the invention, the method comprises acquiring by the one or more of the at least one temperature sensor first temperature data for each location of the at least one location of the first phase at m time points, wherein m is greater than n, and wherein the n time points are consecutive time points of the m time points.

According to the invention, the method comprises acquiring by the one or more of the at least one temperature sensor second temperature data for each location of the at least one location of the second phase at the m time points, wherein m is greater than n, and wherein the n time points are consecutive time points of the m time points.

According to the invention, the method comprises acquiring by the one or more of the at least one temperature sensor third temperature data for each location of the at least one location of the third phase at the m time points, wherein m is greater than n, and wherein the n time points are consecutive time points of the m time points.

In other words, the method involves acquiring temperature data in real time at time steps, and temperature gradient or rate of change of temperatures are determined for each temperature data point as it is acquired, for example via a comparison with the previously acquired temperature point for that location. Then a time window of n data points of temperature data yields n-1 temperature gradient points, and these temperature gradient points can be analysed along with n-1 (or indeed all of the n temperature data points) to determine a state of the switchgear, and this is done for each phase with respect to a location of each phase, that could for example be the location that has the maximum temperature for that phase. Thus, for example a single set of one temperature, and one rate of change of temperature at a time point for each phase can be used as a function of time to determine if there is a problem with one of the phases or a problem with the switchgear overall, but also a time window of multiple consecutive temperature and rate of change of temperature data points for each phase can be analysed to determine the state of the switchgear.

In an example, the method comprises determining each of the n-1 first rates of change of temperature for consecutive temperature data of the n first temperature data for the one or more locations of the first phase.

In an example, the method comprises determining each of the n-1 second rates of change of temperature for consecutive temperature data of the n second temperature data for the one or more locations of the second phase.

In an example, the method comprises determining each of the n-1 third rates of change of temperature for consecutive temperature data of the n third temperature data for the one or more locations of the third phase.

According to the invention, the method comprises determining by the processing unit n-1 first correlation data points, wherein each first correlation data point is a correlation between each first rate of change of temperature of the n-1 first rates of change of temperature with an associated first temperature, wherein for a particular first rate of change of temperature the associated first temperature is a first temperature of two first temperatures used to determine the particular first rate of change of temperature or is a second temperature of the two first temperatures used to determine the particular first rate of change of temperature or is an average of the first temperature and second temperature of the two first temperatures used to determine the particular first rate of change of temperature.

According to the invention, the method comprises determining by the processing unit n-1 second correlation data points, wherein each second correlation data point is a correlation between each second rate of change of temperature of the n-1 second rates of change of temperature with an associated second temperature, wherein for a particular second rate of change of temperature the associated second temperature is a first temperature of two second temperatures used to determine the particular second rate of change of temperature or is a second temperature of the two second temperatures used to determine the particular second rate of change of temperature or is an average of the first temperature and second temperature of the two second temperatures used to determine the particular second rate of change of temperature.

According to the invention, the method comprises determining by the processing unit n-1 third correlation data points, wherein each third correlation data point is a correlation between each third rate of change of temperature of the n-1 third rates of change of temperature with an associated third temperature, wherein for a particular third rate of change of temperature the associated third temperature is a first temperature of two third temperatures used to determine the particular third rate of change of temperature or is a second temperature of the two third temperatures used to determine the particular third rate of change of temperature or is an average of the first temperature and second temperature of the two third temperatures used to determine the particular third rate of change of temperature.

According to the invention, the determining the state of the switchgear comprises utilizing the n-1 first correlation data points, the n-1 second correlation data points, and the n-1 third correlation data points.

It is to be noted that the n-1 correlations data points can be a single correlation of one temperature, and one rate of change of temperature or a time series of this data.

In an example, the determining the state of the switchgear comprises utilizing a shape of the n-1 correlation data points.

In an example, the at least one temperature sensor comprises one or more infrared cameras, and wherein the temperature data for each location of the at least one location for each phase at the n time points is determined from one or more infrared images acquired at each of the n time points.

In an example, the at least one temperature sensor is a single infrared camera.

In an example, the at least one temperature sensor is three infrared cameras, one or for phase.

In an example, the at least one temperature sensor comprises a plurality of point sensors located at the at least one location of the three phases, and wherein the temperature data for the at least one location at the n time points for each phase is acquired by one or more point sensors at each of the n time points.

In an example, the method comprises determining by the processing unit the one or more locations of the at least one location of the first phase as one or more locations with one or more maximum temperatures for the first phase.

In an example, the method comprises determining by the processing unit the one or more locations of the at least one location of the second phase as one or more locations with one or more maximum temperatures for the second phase.

In an example, the method comprises determining by the processing unit the one or more locations of the at least one location of the third phase as one or more locations with one or more maximum temperatures for the third phase.

According to the invention, the method comprises accessing by the processing unit a database of rates of change of temperature data and associated temperature data for three phases of a switchgear, and wherein the determining the state of the switchgear comprises utilizing the database of rates of change of temperature data and associated temperature data.

In an example, the determining the state of the switchgear comprises comparing the n-1 first rates of change of temperature for the one or more locations of the first phase and the at least n-1 of the n first temperature data for the one or more locations of the first phase with the database of rates of change of temperature data and associated temperature data.

In an example, the determining the state of the switchgear comprises comparing the n-1 second rates of change of temperature for the one or more locations of the second phase and the at least n-1 of the n second temperature data for the one or more locations of the second phase with the database of rates of change of temperature data and associated temperature data.

In an example, the determining the state of the switchgear comprises comparing the n-1 third rates of change of temperature for the one or more locations of the third phase and the at least n-1 of the n third temperature data for the one or more locations of the third phase with the database of rates of change of temperature data and associated temperature data.

In an example, the database of rates of change of temperature and associated temperature data comprises data for the at least one location of the switchgear or an equivalent switchgear.

In an example, the database of rates of change of temperature and associated temperature data comprises data at a plurality of time points.

In an example, the method comprises implementing by the processing unit a machine learning algorithm, and wherein the determining the state of the switchgear comprises utilizing the machine learning algorithm, and wherein the machine learning algorithm was trained on the basis of rates of change of temperature data and associated temperature data.

In an example, the rates of change of temperature and associated temperature data used to train the machine leaning algorithm comprises data for the at least one location of each phase of the switchgear or an equivalent switchgear.

In an example, the rates of change of temperature and associated temperature data used to train the machine learning algorithm comprises data at a plurality of time points.

According to the invention, the method comprises:
- acquiring 240 by one or more first current sensors of at least three current sensors first electrical current data for at least one location of the first phase of the switchgear at the n time points;
- acquiring 25) by one or more second current sensors of the at least three current sensors second electrical current data for at least one location of the second phase of the switchgear at the n time points;
- acquiring 260 by one or more third current sensors of the at least three current sensors third electrical current data for at least one location of the third phase of the switchgear at the n time points;
- providing 280 by the at least three current sensors the first electrical current data, the second electrical current data, and the third electrical current data to a processing unit; and
- wherein the determining 320 the state of the switchgear comprises utilizing at least n-1 of the n first electrical current data for the one or more locations of the first phase and at least n-1 of the n second electrical current data for the one or more locations of the second phase and at least n-1 of the n third electrical current data for the one or more locations of the third phase.

Thus, singles values of temperature, rate of change of temperature, and current flow can be acquired in effect at the same time point, or a time series of these values can be utilized.

According to the invention, the determining the state of the switchgear comprises utilizing the n-1 rates of change of temperature for the one or more locations and the n temperature data for the one or more locations at the n time points and the n electrical current data for the one or more locations at the n time points.

In an example, the method comprises acquiring by each current sensor electrical data for the at least one location of the switchgear at m time points, wherein m is greater than n, and wherein the n time points are consecutive time points of the m time points.

In other words, the method involves acquiring temperature data and electrical current data in real time at time steps for each phase, and temperature gradient or rate of change of temperatures are determined for each temperature data point as it is acquired, for example via a comparison with the previously acquired temperature point for that location. Then a time window of n data points of temperature data and electrical current data yields n-1 temperature gradient points (that can be just one temperature value, one temperature gradient value and one electrical current value or a time series of these values) for each phase, and one temperature value, one temperature gradient value and one electrical current value, or a time series of these values, for each phase is analyzed (thus, 9, 18, 27, 36 or any multiple of 9 as n increases) to determine a state of the switchgear.

According to the invention, each first correlation data point is a correlation between each first rate of change of temperature of the n-1 first rates of change of temperature with the associated first temperature and an associated first electrical current data, wherein the associated first electrical current data is one of the two first electrical current data at the two time points when the two first temperature data were acquired that were used to calculate the associated first rate of change of temperature or the associated first electrical current data is an average of the two first electrical current data at the two time points when the two first temperature data were acquired that were used to calculate the associated first rate of change of temperature.

According to the invention, each second correlation data point is a correlation between each second rate of change of temperature of the n-1 second rates of change of temperature with the associated second temperature and an associated second electrical current data, wherein the associated second electrical current data is one of the two second electrical current data at the two time points when the two second temperature data were acquired that were used to calculate the associated second rate of change of temperature or the associated second electrical current data is an average of the two second electrical current data at the two time points when the two second temperature data were acquired that were used to calculate the associated second rate of change of temperature.

According to the invention, each third correlation data point is a correlation between each third rate of change of temperature of the n-1 third rates of change of temperature with the associated third temperature and an associated third electrical current data, wherein the associated third electrical current data is one of the two third electrical current data at the two time points when the two third temperature data were acquired that were used to calculate the associated third rate of change of temperature or the associated third electrical current data is an average of the two third electrical current data at the two time points when the two third temperature data were acquired that were used to calculate the associated third rate of change of temperature.

In an example, the determining the state of the switchgear comprises utilizing a shape of the n-1 correlation data points for each phase.

According to the invention, the method comprises outputting by the output unit the determined state of the switchgear when the determined state of the switchgear is determined to be normal or to be healthy.

In an example, the determined state of the switchgear comprises an indication that overheating is occurring.

In an example, the determined state of the switchgear comprises an indication that overheating will occur.

In an example, the determined state of the switchgear comprises an indication that overheating is occurring due to high current flow.

In an example, the determined state of the switchgear comprises an indication that overheating is occurring due to a component failure.

In an example, the component failure can be indicated as increased resistance and/or joint failure, for example based on the location of a maximum temperature.

In an example, the determined state of the switchgear comprises an indication of a fault in one of the three phases.

In an example, the determined state of the switchgear comprises an indication of an increased current load in one of the three phases.

In an example, the determined state of the switchgear comprises an indication of a location of the one or more locations.

In an example, the method comprises accessing by the processing unit a database of rates of change of temperature data and associated temperature data and associated electrical current data for three phases of a switchgear, and wherein the determining the state of the switchgear comprises utilizing the database of rates of change of temperature data and associated temperature data and associated electrical current data.

In an example, the determining the state of the switchgear comprises comparing the n-1 first rates of change of temperature for the one or more locations of the first phase and the at least n-1 of the n first temperature data for the one or more locations of the first phase and the at least n-1 of the n first electrical current data for the one or more locations of the first phase with the database of rates of change of temperature data and associated temperature data and associated electrical current data.

In an example, the determining the state of the switchgear comprises comparing the n-1 second rates of change of temperature for the one or more locations of the second phase and the at least n-1 of the n second temperature data for the one or more locations of the second phase and the at least n-1 of the n second electrical current data for the one or more locations of the second phase with the database of rates of change of temperature data and associated temperature data and associated electrical current data.

In an example, the determining the state of the switchgear comprises comparing the n-1 third rates of change of temperature for the one or more locations of the third phase and the at least n-1 of the n third temperature data for the one or more locations of the third phase and the at least n-1 of the n third electrical current data for the one or more locations of the third phase with the database of rates of change of temperature data and associated temperature data and associated electrical current data.

In an example, the database of rates of change of temperature and associated temperature data and associated electrical current data comprises data for the at least one location of the switchgear or an equivalent switchgear.

In an example, the database of rates of change of temperature and associated temperature data and associated electrical current data comprises data at a plurality of time points.

In an example, the method comprises implementing by the processing unit a machine learning algorithm, and wherein the determining the state of the switchgear comprises utilizing the machine learning algorithm, and wherein the machine learning algorithm was trained on the basis of rates of change of temperature data and associated temperature data and associated electrical current data.

In an example, the rates of change of temperature and associated temperature data and associated electrical current data used to train the machine leaning algorithm comprises data for the at least one location of each phase of the switchgear or an equivalent switchgear

In an example, the rates of change of temperature and associated temperature data and associated electrical current data used to train the machine learning algorithm comprises data at a plurality of time points.

The system and method for monitoring a switchgear is described in further detail, with respect to specific embodiments, where reference is made to Figs. 3-5.

Fig. 3 shows a plot of rate of change of temperature against temperature for a number of locations for one phase in a compartment of a switchgear. Each point relates to a point in time, and in this case the temperature increases as time progresses. The top curves represent cases, where there is a fault in the phase of the switchgear and overheating is occurring. The bottom region, represented as a hashed region, has the same 5 curves for the heating up where no fault is present. The box indicates that 5 data points are being analyzed where the data were acquired in effect at 5 time points (there are actually 6 time points to determine the 5 rates of change of temperature but the only 5 temperatures are correlated or paired with the associated rate of change of temperature). Thus if all the data were considered to have already been acquired the box would move gradually to the right, containing 5 data points at a time. These 5 data points in terms of their temperature and temperature gradients provide information on how a location of the switchgear is heating up, and whether that heating up in normal or abnormal. In Fig. 3 the fault is such that the top curves are significantly above the "healthy" curves, which has been done for ease of visibility, but less significant faults can be detected, where the curve is within or close to a region of normality, but its shape (of the 5 points) is such that it can be determined that there is a problem. Here, 5 data points is used as an example, and there can be fewer than this or many more that are analyzed. Indeed just one data point of temperature and rate of change of temperature can be utilized. As shown in Fig. 4 this data, in terms of temperatures and determined rates of change of temperature are also acquired for the other two phases, and this data is analyzed to determine a fault in a phase. This data can be analyzed for a location of each phase that exhibits a maximum temperature. However, each phase will have a current load and this value is also measured and correlated with the temperature and rate of change of temperature information. This enables it to be determined with certainty if overheating is being caused by a fault, such as a loose joint on increased resistance of a connection or current carry part such as busbar, for example due to a crack, or is due to an abnormally high current load, but where all the components are otherwise operating correctly.

One approach is to acquire temperature and temperature gradient data, and current load data, for each phase to provide in effect a time varying three dimensional look up table. This can be compared with reference three dimensional look up tables, enabling it to be determined if overheating is occurring, such as a loose joint or a higher than expected resistance within a busbar for example. Interpolation algorithms can be utilized mitigating the need to generate an excessive number of reference look up tables.

Another approach is to train a machine learning algorithm, such as a neural network on the basis of temperature and temperature gradient data, and also optionally current load data, for each phase for situations where a switchgear equivalent to the one operating is working correctly. Real data can then be analyzed to determine if overheating is occurring. The machine learning algorithm can also be trained with data relating to faults, through loosening joints at different locations, and for example replacing current carrying elements, for example a busbar, with a component with an intentionally higher than normal resistance at a position along its length.

In a specific embodiment, for monitoring 3 compartments of a switchgear an infrared camera can be located to view internally within each compartment or a number of point temperature sensors can be located within each compartment, where a phase is located in each compartment. The system then takes the highest temperature from each compartment for each phase (3 values in this example at each time point) and additionally computes the gradient over time for each of those (another 3 values in effect at each time point). These values are used as input for a machine learning algorithm. As detailed above, the current load for each phase can also be acquired and also input to the machine leaning algorithm. All three phases could be in a single compartment, and a single infrared camera could acquire all the temperature data at different locations of each phase

Thus, in a specific embodiment at each time point there are n temperatures, n temperature gradients for each phase, that are used to describe a situation, optionally with current load data for each phase at this time point. The situation can be labeled as either healthy or faulty, and a label can be used that indicates future overheating will occur.

Thus, a switchgear has three phases, and there are p data points acquired at each time point (temperature and rate of change of temperature and optionally electrical current load), thus p is equal to 2 or 3. Then, a length of a time series is of data being analyzed is n-1, where for example 2 temperatures are acquired to determine a single rate of change of temperature. Then the array of 3x3x(n-1) data points are utilized for analysis. The time series number n could also be of variable length, e.g., when using LSTM neural networks.)

A basic Support Vector Machine or Neural Network can be used but a special case would be to use a 1D-convolutional neural network to use the shape-recognition capability of the convolutional layers on the time series.

This input, for a real system is provided to a trained machine learning algorithm. The equivalent input, for example for a reference switchgear that can operate in healthy modes, and if necessary with faults, is used to provide equivalent data as input to train such a classification algorithm. There are different sets of labels one could apply coming from the following list: healthy, faulty, soon to overheat, current overload, phase imbalance. Healthy means that there is no fault. Faulty means that there is some fault. 'Soon to overheat' means that if nothing else changes, a temperature threshold will be exceeded soon. 'Current overload' means that the equipment is used beyond its ratings but there is no defect. 'Imbalance' means that not all phases carry the same current.

The system can be trained by providing situational data for each of the labels in enough quantity to describe the expected future input.

Furthermore, the system can be trained separately for heat-up and cool-down phases to address the different behavior in those modes of operation.

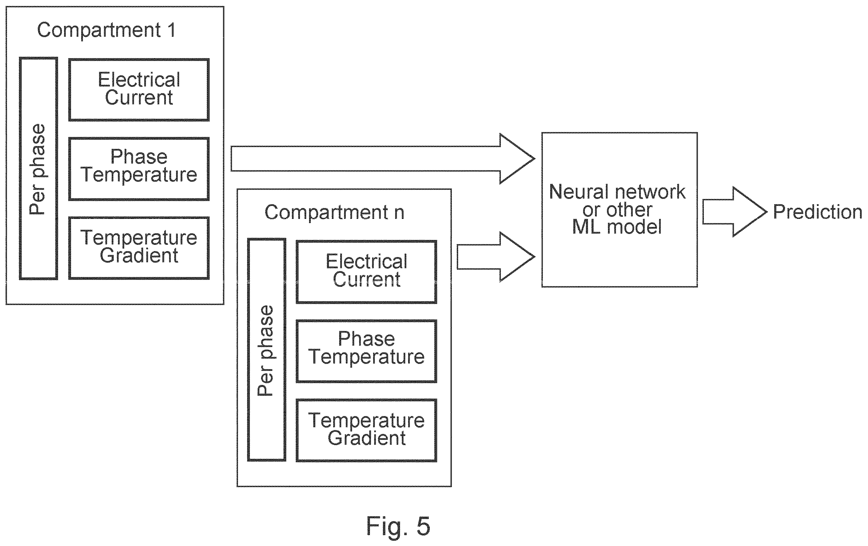

This is shown schematically in Fig. 5.

There are different sets of labels that can apply coming from the following list: healthy, faulty, soon to overheat, current overload, phase imbalance. Healthy means that there is no fault. Faulty means that there is some fault. 'Soon to overheat' means that if nothing else changes, a temperature threshold will be exceeded soon. 'Current overload' means that the equipment is used beyond its ratings but there is no defect. 'Imbalance' means that not all phases carry the same current. The system can be trained by providing situational data for each of the labels in enough quantity to describe the expected future input.

According to the invention, computer program element is provided that is characterized by being configured to execute the method steps of the method according to one of the preceding embodiments, on an appropriate processor or system.

The computer program element might therefore be stored on a computer unit, which might also be part of an embodiment. This computing unit may be configured to perform or induce performing of the steps of the method described above. Moreover, it may be configured to operate the components of the above described system. The computing unit can be configured to operate automatically and/or to execute the orders of a user. A computer program may be loaded into a working memory of a data processor. The data processor may thus be equipped to carry out the method according to one of the preceding embodiments.

This exemplary embodiment of the invention covers both, a computer program that right from the beginning uses the invention and computer program that by means of an update turns an existing program into a program that uses the invention.

Further on, the computer program element might be able to provide all necessary steps to fulfill the procedure of an exemplary embodiment of the method as described above.

According to a further exemplary embodiment of the present invention, a computer readable medium, such as a CD-ROM, USB stick or the like, is presented wherein the computer readable medium has a computer program element stored on it which computer program element is described by the preceding section.

A computer program may be stored and/or distributed on a suitable medium, such as an optical storage medium or a solid state medium supplied together with or as part of other hardware, but may also be distributed in other forms, such as via the internet or other wired or wireless telecommunication systems.

However, the computer program may also be presented over a network like the World Wide Web and can be downloaded into the working memory of a data processor from such a network. According to a further exemplary embodiment of the present invention, a medium for making a computer program element available for downloading is provided, which computer program element is arranged to perform a method according to one of the previously described embodiments of the invention.

## Claims

1. A system (10) for monitoring a three phase switchgear, the system comprising:
- at least one temperature sensor (20);
- a processing unit (30);
- at least three current sensors (90, 100, 110); and
- an output unit (40);
wherein one or more of the at least one temperature sensor is configured to acquire first temperature data for each location of at least one location of a first phase (50) of a switchgear (80) at n time points;
wherein one or more of the at least one temperature sensor is configured to acquire second temperature data for each location of at least one location of a second phase (60) of the switchgear at the n time points;
wherein one or more of the at least one temperature sensor is configured to acquire third temperature data for each location of at least one location of a third phase (70) of the switchgear at the n time points;
wherein the at least one temperature sensor is configured to provide the first temperature data, the second temperature data, and the third temperature data to the processing unit;
wherein one or more first current sensors of the at least three current sensors are configured to acquire first electrical current data for at least one location of the first phase of the switchgear at the n time points;
wherein one or more second current sensors of the at least three current sensors are configured to acquire second electrical current data for at least one location of the second phase of the switchgear at the n time points;
wherein one or more third current sensors of the at least three current sensors are configured to acquire third electrical current data for at least one location of the third phase of the switchgear at the n time points;
wherein the at least three current sensors are configured to provide the first electrical current data, the second electrical current data, and the third electrical current data to the processing unit;
wherein the processing unit is configured to determine n-1 first rates of change of temperature for one or more locations of the at least one location of the first phase with respect to the n first temperature data for the one or more locations of the first phase at the n time points;
wherein the processing unit is configured to determine n-1 second rates of change of temperature for one or more locations of the at least one location of the second phase with respect to the n second temperature data for the one or more locations of the second phase at the n time points;
wherein the processing unit is configured to determine n-1 third rates of change of temperature for one or more locations of the at least one location of the third phase with respect to the n third temperature data for the one or more locations of the third phase at the n time points;
wherein the processing unit is configured to determine n-1 first correlation data points, wherein each first correlation data point is a correlation between each first rate of change of temperature of the n-1 first rates of change of temperature with an associated first temperature and an associated first electrical current data, wherein the associated first electrical current data is one of the two first electrical current data at the two time points when the two first temperature data were acquired that were used to calculate the associated first rate of change of temperature or the associated first electrical current data is an average of the two first electrical current data at the two time points when the two first temperature data were acquired that were used to calculate the associated first rate of change of temperature, wherein for a particular first rate of change of temperature the associated first temperature is a first temperature of two first temperatures used to determine the particular first rate of change of temperature or is a second temperature of the two first temperatures used to determine the particular first rate of change of temperature or is an average of the first temperature and second temperature of the two first temperatures used to determine the particular first rate of change of temperature;
wherein the processing unit is configured to determine n-1 second correlation data points, wherein each second correlation data point is a correlation between each second rate of change of temperature of the n-1 second rates of change of temperature with an associated second temperature and an associated second electrical current data, wherein the associated second electrical current data is one of the two second electrical current data at the two time points when the two second temperature data were acquired that were used to calculate the associated second rate of change of temperature or the associated second electrical current data is an average of the two second electrical current data at the two time points when the two second temperature data were acquired that were used to calculate the associated second rate of change of temperature , wherein for a particular second rate of change of temperature the associated second temperature is a first temperature of two second temperatures used to determine the particular second rate of change of temperature or is a second temperature of the two second temperatures used to determine the particular second rate of change of temperature or is an average of the first temperature and second temperature of the two second temperatures used to determine the particular second rate of change of temperature;
wherein the processing unit is configured to determine n-1 third correlation data points, wherein each third correlation data point is a correlation between each third rate of change of temperature of the n-1 third rates of change of temperature with an associated third temperature and an associated third electrical current data, wherein the associated third electrical current data is one of the two third electrical current data at the two time points when the two third temperature data were acquired that were used to calculate the associated third rate of change of temperature or the associated third electrical current data is an average of the two third electrical current data at the two time points when the two third temperature data were acquired that were used to calculate the associated third rate of change of temperature, wherein for a particular third rate of change of temperature the associated third temperature is a first temperature of two third temperatures used to determine the particular third rate of change of temperature or is a second temperature of the two third temperatures used to determine the particular third rate of change of temperature or is an average of the first temperature and second temperature of the two third temperatures used to determine the particular third rate of change of temperature;
wherein the processing unit is configured to determine a state of the switchgear, wherein the determination of the state of the switchgear comprises utilization of the n-1 first rates of change of temperature for the one or more locations of the first phase and at least n-1 of the n first temperature data for the one or more locations of the first phase and the n-1 second rates of change of temperature for the one or more locations of the second phase and at least n-1 of the n second temperature data for the one or more locations of the second phase and the n-1 third rates of change of temperature for the one or more locations of the third phase and at least n-1 of the n third temperature data for the one or more locations of the third phase and at least n-1 of the n first electrical current data for the one or more locations of the first phase and at least n-1 of the n second electrical current data for the one or more locations of the second phase and at least n-1 of the n third electrical current data for the one or more locations of the third phase and the n-1 first correlation data points and the n-1 second correlation data points and the n-1 third correlation data points; and
wherein the output unit is configured to output the determined state of the switchgear when the determined state of the switchgear is determined not to be normal or not to be healthy.

2. System according to claim 1, wherein the one or more of the at least one temperature sensor is configured to acquire first temperature data for each location of the at least one location of the first phase at m time points, wherein m is greater than n, and wherein the n time points are consecutive time points of the m time points; wherein the one or more of the at least one temperature sensor is configured to acquire second temperature data for each location of the at least one location of the second phase at the m time points, wherein m is greater than n, and wherein the n time points are consecutive time points of the m time points; wherein the one or more of the at least one temperature sensor is configured to acquire third temperature data for each location of the at least one location of the third phase at the m time points, wherein m is greater than n, and wherein the n time points are consecutive time points of the m time points.

3. System according to any of claims 1-2, wherein each of the n-1 first rates of change of temperature are determined for consecutive temperature data of the n first temperature data for the one or more locations of the first phase; wherein each of the n-1 second rates of change of temperature are determined for consecutive temperature data of the n second temperature data for the one or more locations of the second phase; and wherein each of the n-1 third rates of change of temperature are determined for consecutive temperature data of the n third temperature data for the one or more locations of the third phase.

4. System according to any of claims 1-3, wherein the at least one temperature sensor comprises one or more infrared cameras, and wherein the temperature data for each location of the at least one location for each phase at the n time points is determined from one or more infrared images acquired at each of the n time points.

5. System according to claim 1-3, wherein the at least one temperature sensor comprises a plurality of point sensors located at the at least one location of the three phases, and wherein the temperature data for the at least one location at the n time points for each phase is acquired by one or more point sensors at each of the n time points.

6. System according to any of claims 1-5, wherein the one or more locations of the at least one location of the first phase are determined as one or more locations with one or more maximum temperatures for the first phase; wherein the one or more locations of the at least one location of the second phase are determined as one or more locations with one or more maximum temperatures for the second phase; and wherein the one or more locations of the at least one location of the third phase are determined as one or more locations with one or more maximum temperatures for the third phase.

7. System according to any of claims 1-6, wherein the processing unit is configured to access a database of rates of change of temperature data and associated temperature data for three phases of a switchgear, and wherein the determination of the state of the switchgear comprises utilization of the database of rates of change of temperature data and associated temperature data.

8. System according to any of claims 1-7, wherein the processing unit is configured to implement a machine learning algorithm, and wherein the determination of the state of the switchgear comprises utilization of the machine learning algorithm, and wherein the machine learning algorithm was trained on the basis of rates of change of temperature data and associated temperature data.

9. System according to any of claims 1-8, wherein the processing unit is configured to access a database of rates of change of temperature data and associated temperature data and associated electrical current data for three phases of a switchgear, and wherein the determination of the state of the switchgear comprises utilization of the database of rates of change of temperature data and associated temperature data and associated electrical current data.

10. System according to claim 9, wherein the determination of the state of the switchgear comprises a comparison of the n-1 first rates of change of temperature for the one or more locations of the first phase and the at least n-1 of the n first temperature data for the one or more locations of the first phase and the at least n-1 of the n first electrical current data for the one or more locations of the first phase with the database of rates of change of temperature data and associated temperature data and associated electrical current data, and a comparison of the n-1 second rates of change of temperature for the one or more locations of the second phase and the at least n-1 of the n second temperature data for the one or more locations of the second phase and the at least n-1 of the n second electrical current data for the one or more locations of the second phase with the database of rates of change of temperature data and associated temperature data and associated electrical current data, and a comparison of the n-1 third rates of change of temperature for the one or more locations of the third phase and the at least n-1 of the n third temperature data for the one or more locations of the third phase and the at least n-1 of the n third electrical current data for the one or more locations of the third phase with the database of rates of change of temperature data and associated temperature data and associated electrical current data.

11. System according to any of claims 1-8, wherein the processing unit is configured to implement a machine learning algorithm, and wherein the determination of the state of the switchgear comprises utilization of the machine learning algorithm, and wherein the machine learning algorithm was trained on the basis of rates of change of temperature data and associated temperature data and associated electrical current data.

12. A switchgear (80) comprising a system (10) according to any of claims 1-11.

13. A method (200) for monitoring a three phase switchgear, the method comprising:
- acquiring (210) by one or more of at least one temperature sensor first temperature data for each location of at least one location of a first phase of a switchgear at n time points;
- acquiring (220) by one or more of the at least one temperature sensor second temperature data for each location of at least one location of a second phase of the switchgear at the n time points;
- acquiring (230) by one or more of the at least one temperature sensor third temperature data for each location of at least one location of a third phase of the switchgear at the n time points;
- acquiring (240) by one or more first current sensors of at least three current sensors first electrical current data for at least one location of the first phase of the switchgear at the n time points;
- acquiring (250) by one or more second current sensors of the at least three current sensors second electrical current data for at least one location of the second phase of the switchgear at the n time points;
- acquiring (260) by one or more third current sensors of the at least three current sensors third electrical current data for at least one location of the third phase of the switchgear at the n time points;
- providing (270) by the at least one temperature sensor the first temperature data, the second temperature data, and the third temperature data to a processing unit;
- providing (280) by the at least three current sensors the first electrical current data, the second electrical current data, and the third electrical current data to a processing unit;
- determining (290) by the processing unit n-1 first rates of change of temperature for one or more locations of the at least one location of the first phase with respect to the n first temperature data for the one or more locations of the first phase at the n time points;
- determining (300) by the processing unit n-1 second rates of change of temperature for one or more locations of the at least one location of the second phase with respect to the n second temperature data for the one or more locations of the second phase at the n time points;
- determining (310) by the processing unit n-1 third rates of change of temperature for one or more locations of the at least one location of the third phase with respect to the n third temperature data for the one or more locations of the third phase at the n time points;
determining by the processing unit n-1 first correlation data points, wherein each first correlation data point is a correlation between each first rate of change of temperature of the n-1 first rates of change of temperature with an associated first temperature and an associated first electrical current data, wherein the associated first electrical current data is one of the two first electrical current data at the two time points when the two first temperature data were acquired that were used to calculate the associated first rate of change of temperature or the associated first electrical current data is an average of the two first electrical current data at the two time points when the two first temperature data were acquired that were used to calculate the associated first rate of change of temperature, wherein for a particular first rate of change of temperature the associated first temperature is a first temperature of two first temperatures used to determine the particular first rate of change of temperature or is a second temperature of the two first temperatures used to determine the particular first rate of change of temperature or is an average of the first temperature and second temperature of the two first temperatures used to determine the particular first rate of change of temperature;
determining by the processing unit n-1 second correlation data points, wherein each second correlation data point is a correlation between each second rate of change of temperature of the n-1 second rates of change of temperature with an associated second temperature and an associated second electrical current data, wherein the associated second electrical current data is one of the two second electrical current data at the two time points when the two second temperature data were acquired that were used to calculate the associated second rate of change of temperature or the associated second electrical current data is an average of the two second electrical current data at the two time points when the two second temperature data were acquired that were used to calculate the associated second rate of change of temperature , wherein for a particular second rate of change of temperature the associated second temperature is a first temperature of two second temperatures used to determine the particular second rate of change of temperature or is a second temperature of the two second temperatures used to determine the particular second rate of change of temperature or is an average of the first temperature and second temperature of the two second temperatures used to determine the particular second rate of change of temperature;
determining by the processing unit n-1 third correlation data points, wherein each third correlation data point is a correlation between each third rate of change of temperature of the n-1 third rates of change of temperature with an associated third temperature and an associated third electrical current data, wherein the associated third electrical current data is one of the two third electrical current data at the two time points when the two third temperature data were acquired that were used to calculate the associated third rate of change of temperature or the associated third electrical current data is an average of the two third electrical current data at the two time points when the two third temperature data were acquired that were used to calculate the associated third rate of change of temperature, wherein for a particular third rate of change of temperature the associated third temperature is a first temperature of two third temperatures used to determine the particular third rate of change of temperature or is a second temperature of the two third temperatures used to determine the particular third rate of change of temperature or is an average of the first temperature and second temperature of the two third temperatures used to determine the particular third rate of change of temperature
- determining (320) by the processing unit a state of the switchgear, wherein the determination of the state of the switchgear comprises utilization of the n-1 first rates of change of temperature for the one or more locations of the first phase and at least n-1 of the n first temperature data for the one or more locations of the first phase and the n-1 second rates of change of temperature for the one or more locations of the second phase and at least n-1 of the n second temperature data for the one or more locations of the second phase and the n-1 third rates of change of temperature for the one or more locations of the third phase and at least n-1 of the n third temperature data for the one or more locations of the third phase and at least n-1 of the n first electrical current data for the one or more locations of the first phase and at least n-1 of the n second electrical current data for the one or more locations of the second phase and at least n-1 of the n third electrical current data for the one or more locations of the third phase and the n-1 first correlation data points and the n-1 second correlation data points and the n-1 third correlation data points; and
- outputting (330) by an output unit the determined state of the switchgear when the determined state of the switchgear is determined not to be normal or not to be healthy.

14. A computer program element for controlling a system according to any of claims 1-11 which when executed by the processing unit (30) is configured to carry out the method of claim 13.

## Patentansprüche

1. Ein System (10) zur Überwachung einer dreiphasigen Schaltanlage, wobei das System umfasst:
- mindestens einen Temperatursensor (20);
- eine Verarbeitungseinheit (30);
- mindestens drei Stromsensoren (90, 100, 110); und
- eine Ausgabeeinheit (40);
wobei einer oder mehrere der mindestens einen Temperatursensoren derart eingerichtet sind, dass sie erste Temperaturdaten für jeden Ort mindestens eines Ortes einer ersten Phase (50) einer Schaltanlage (80) zu n Zeitpunkten erfassen;
wobei einer oder mehrere der mindestens einen Temperatursensoren derart eingerichtet sind, dass sie zweite Temperaturdaten für jeden Ort mindestens eines Ortes einer zweiten Phase (60) der Schaltanlage zu den n Zeitpunkten erfassen;
wobei einer oder mehrere der mindestens einen Temperatursensoren derart eingerichtet sind, dass sie dritte Temperaturdaten für jeden Ort mindestens eines Ortes einer dritten Phase (70) der Schaltanlage zu den n Zeitpunkten erfassen;
wobei der mindestens eine Temperatursensor derart eingerichtet ist, dass er die ersten Temperaturdaten, die zweiten Temperaturdaten und die dritten Temperaturdaten an die Verarbeitungseinheit liefert;
wobei einer oder mehrere der mindestens drei Stromsensoren derart eingerichtet sind, dass sie erste elektrische Stromdaten für mindestens einen Ort der ersten Phase der Schaltanlage zu den n Zeitpunkten erfassen;
wobei ein oder mehrere zweite Stromsensoren der mindestens drei Stromsensoren derart eingerichtet sind, dass sie zweite elektrische Stromdaten für mindestens einen Ort der zweiten Phase der Schaltanlage zu den n Zeitpunkten erfassen;
wobei ein oder mehrere dritte Stromsensoren der mindestens drei Stromsensoren derart eingerichtet sind, dass sie dritte elektrische Stromdaten für mindestens einen Ort der dritten Phase der Schaltanlage zu den n Zeitpunkten erfassen;
wobei die mindestens drei Stromsensoren derart eingerichtet sind, dass sie die ersten elektrischen Stromdaten, die zweiten elektrischen Stromdaten und die dritten elektrischen Stromdaten an die Verarbeitungseinheit liefern;
wobei die Verarbeitungseinheit derart eingerichtet ist, dass sie n-1 erste Temperaturänderungsraten für einen oder mehrere Orte dem mindestens einen Ort der ersten Phase in Bezug auf die n ersten Temperaturdaten für den einen oder die mehreren Orte der ersten Phase zu den n Zeitpunkten bestimmt;
wobei die Verarbeitungseinheit derart eingerichtet ist, dass sie n-1 zweite Temperaturänderungsraten für einen oder mehrere Orte des mindestens einen Ortes der zweiten Phase in Bezug auf die n zweiten Temperaturdaten für den einen oder die mehreren Orte der zweiten Phase zu den n Zeitpunkten bestimmt;
wobei die Verarbeitungseinheit derart eingerichtet ist, dass sie n-1 dritte Temperaturänderungsraten für einen oder mehrere Orte des mindestens einen Ortes der dritten Phase in Bezug auf die n dritten Temperaturdaten für den einen oder die mehreren Orte der dritten Phase zu den n Zeitpunkten bestimmt;
wobei die Verarbeitungseinheit derart eingerichtet ist, dass sie n-1 erste Korrelationsdatenpunkte bestimmt, wobei jeder erste Korrelationsdatenpunkt eine Korrelation zwischen jeder ersten Temperaturänderungsrate der n-1 ersten Temperaturänderungsraten mit einer zugehörigen ersten Temperatur und einer zugehörigen ersten elektrischen Stromdaten ist, wobei die zugehörigen ersten elektrischen Stromdaten eine der beiden ersten elektrischen Stromdaten zu den beiden Zeitpunkten sind, zu denen die beiden ersten Temperaturdaten erfasst wurden, die zur Berechnung der zugehörigen ersten Temperaturänderungsrate verwendet wurden, oder die zugehörigen ersten elektrischen Stromdaten ein Durchschnitt der beiden ersten elektrischen Stromdaten zu den beiden Zeitpunkten sind, zu denen die beiden ersten Temperaturdaten erfasst wurden, die zur Berechnung der zugehörigen ersten Temperaturänderungsrate verwendet wurden, wobei für eine bestimmte erste Temperaturänderungsrate die zugehörige erste Temperatur eine erste Temperatur von zwei ersten Temperaturen ist, die zur Bestimmung der bestimmten ersten Temperaturänderungsrate verwendet wurden, oder eine zweite Temperatur der beiden ersten Temperaturen ist, die zur Bestimmung der bestimmten ersten Temperaturänderungsrate verwendet wurden, oder ein Durchschnitt der ersten Temperatur und der zweiten Temperatur der beiden ersten Temperaturen ist, die zur Bestimmung der bestimmten ersten Temperaturänderungsrate verwendet wurden;
wobei die Verarbeitungseinheit derart eingerichtet ist, dass sie n-1 zweite Korrelationsdatenpunkte bestimmt, wobei jeder zweite Korrelationsdatenpunkt eine Korrelation zwischen jeder zweiten Temperaturänderungsrate der n-1 zweiten Temperaturänderungsraten mit einer zugehörigen zweiten Temperatur und einem zugehörigen zweiten elektrischen Stromdatenpunkt ist, wobei die zugehörigen zweiten elektrischen Stromdaten einer der beiden zweiten elektrischen Stromdaten zu den beiden Zeitpunkten sind, zu denen die beiden zweiten Temperaturdaten erfasst wurden, die zur Berechnung der zugehörigen zweiten Temperaturänderungsrate verwendet wurden, oder die zugehörigen zweiten elektrischen Stromdaten ein Durchschnitt der beiden zweiten elektrischen Stromdaten zu den beiden Zeitpunkten sind, zu denen die beiden zweiten Temperaturdaten erfasst wurden, die zur Berechnung der zugehörigen zweiten Temperaturänderungsrate verwendet wurden, wobei für eine bestimmte zweite Temperaturänderungsrate die zugehörige zweite Temperatur eine erste Temperatur von zwei zweiten Temperaturen ist, die zur Bestimmung der bestimmten zweiten Temperaturänderungsrate verwendet wurden, oder eine zweite Temperatur der beiden zweiten Temperaturen ist, die zur Bestimmung der bestimmten zweiten Temperaturänderungsrate verwendet wurden, oder ein Durchschnitt der ersten Temperatur und der zweiten Temperatur der beiden zweiten Temperaturen ist, die zur Bestimmung der bestimmten zweiten Temperaturänderungsrate verwendet wurden;
wobei die Verarbeitungseinheit derart eingerichtet ist, dass sie n-1 dritte Korrelationsdatenpunkte bestimmt, wobei jeder dritte Korrelationsdatenpunkt eine Korrelation zwischen jeder dritten Temperaturänderungsrate der n-1 dritten Temperaturänderungsraten mit einer zugehörigen dritten Temperatur und einem zugehörigen dritten elektrischen Stromdatenpunkt ist, wobei die zugehörigen dritten elektrischen Stromdaten eine der beiden dritten elektrischen Stromdaten zu den beiden Zeitpunkten sind, zu denen die beiden dritten Temperaturdaten erfasst wurden, die zur Berechnung der zugehörigen dritten Temperaturänderungsrate verwendet wurden, oder die zugehörigen dritten elektrischen Stromdaten ein Durchschnitt der beiden dritten elektrischen Stromdaten zu den beiden Zeitpunkten sind, zu denen die beiden dritten Temperaturdaten erfasst wurden, die zur Berechnung der zugehörigen dritten Temperaturänderungsrate verwendet wurden, wobei für eine bestimmte dritte Temperaturänderungsrate die zugehörige dritte Temperatur eine erste Temperatur von zwei dritten Temperaturen ist, die zur Bestimmung der bestimmten dritten Temperaturänderungsrate verwendet wurden, oder eine zweite Temperatur der beiden dritten Temperaturen ist, die zur Bestimmung der bestimmten dritten Temperaturänderungsrate verwendet wurden, oder ein Durchschnitt der ersten Temperatur und der zweiten Temperatur der beiden dritten Temperaturen ist, die zur Bestimmung der bestimmten dritten Temperaturänderungsrate verwendet wurden;
wobei die Verarbeitungseinheit derart eingerichtet ist, dass sie einen Zustand der Schaltanlage bestimmt, wobei die Bestimmung des Zustands der Schaltanlage die Verwendung der n-1 ersten Temperaturänderungen für den einen oder die mehreren Orte der ersten Phase und mindestens n-1 der n ersten Temperaturdaten für den einen oder die mehreren Orte der ersten Phase und der n-1 zweiten Temperaturänderungsraten für den einen oder die mehreren Orte der zweiten Phase und mindestens n-1 der n zweiten Temperaturdaten für den einen oder die mehreren Orte der zweiten Phase und die n-1 dritten Temperaturänderungsraten für den einen oder die mehreren Orte der dritten Phase und mindestens n-1 der n dritten Temperaturdaten für den einen oder die mehreren Orte der dritten Phase und mindestens n-1 der n ersten elektrischen Stromdaten für den einen oder die mehreren Orte der ersten Phase und mindestens n-1 der n zweiten elektrischen Stromdaten für den einen oder die mehreren Orte der zweiten Phase und mindestens n-1 der n dritten elektrischen Stromdaten für den einen oder die mehreren Orte der dritten Phase und die n-1 ersten Korrelationsdatenpunkte und die n-1 zweiten Korrelationsdatenpunkte und die n-1 dritten Korrelationsdatenpunkte; und
wobei die Ausgabeeinheit derart eingerichtet ist, dass sie den ermittelten Zustand der Schaltanlage ausgibt, wenn der ermittelte Zustand der Schaltanlage als nicht normal oder nicht intakt ermittelt wird.

2. System gemäß Anspruch 1, wobei der eine oder die mehreren der mindestens einen Temperatursensoren derart eingerichtet sind, dass sie erste Temperaturdaten für jeden Ort des mindestens einen Ortes der ersten Phase zu m Zeitpunkten erfassen, wobei m größer als n ist und wobei die n Zeitpunkte aufeinanderfolgende Zeitpunkte der m Zeitpunkte sind; wobei der eine oder die mehreren der mindestens einen Temperatursensoren derart eingerichtet sind, dass sie zweite Temperaturdaten für jeden Ort des mindestens einen Ortes der zweiten Phase zu den m Zeitpunkten erfassen, wobei m größer als n ist und wobei die n Zeitpunkte aufeinanderfolgende Zeitpunkte der m Zeitpunkte sind; wobei der eine oder die mehreren der mindestens einen Temperatursensoren derart eingerichtet sind, dass sie dritte Temperaturdaten für jeden Ort des mindestens einen Ortes der dritten Phase zu den m Zeitpunkten erfassen, wobei m größer als n ist und wobei die n Zeitpunkte aufeinanderfolgende Zeitpunkte der m Zeitpunkte sind.

3. System gemäß einem der Ansprüche 1-2, wobei jede der n-1 ersten Temperaturänderungsraten für aufeinanderfolgende Temperaturdaten der n ersten Temperaturdaten für den einen oder die mehreren Orte der ersten Phase bestimmt wird; wobei jede der n-1 zweiten Temperaturänderungsraten für aufeinanderfolgende Temperaturdaten der n zweiten Temperaturdaten für den einen oder die mehreren Orte der zweiten Phase bestimmt wird; und wobei jede der n-1 dritten Temperaturänderungsraten für aufeinanderfolgende Temperaturdaten der n dritten Temperaturdaten für den einen oder die mehreren Orte der dritten Phase bestimmt wird.

4. System gemäß einem der Ansprüche 1-3, wobei der mindestens eine Temperatursensor eine oder mehrere Infrarotkameras umfasst und wobei die Temperaturdaten für jeden Ort des mindestens einen Ortes für jede Phase zu den n Zeitpunkten aus einem oder mehreren Infrarotbildern bestimmt werden, die zu jedem der n Zeitpunkte aufgenommen wurden.

5. System gemäß Anspruch 1-3, wobei der mindestens eine Temperatursensor eine Vielzahl von Punktsensoren umfasst, die an dem mindestens einen Ort der drei Phasen angeordnet sind, und wobei die Temperaturdaten für den mindestens einen Ort zu den n Zeitpunkten für jede Phase durch einen oder mehrere Punktsensoren zu jedem der n Zeitpunkte erfasst werden.

6. System gemäß einem der Ansprüche 1-5, wobei der eine oder die mehreren Orte des mindestens einen Ortes der ersten Phase als ein oder mehrere Orte mit einer oder mehreren Maximaltemperaturen für die erste Phase bestimmt werden; wobei der eine oder die mehreren Orte des mindestens einen Ortes der zweiten Phase als ein oder mehrere Orte mit einer oder mehreren Maximaltemperaturen für die zweite Phase bestimmt werden; und wobei der eine oder die mehreren Orte des mindestens einen Ortes der dritten Phase als ein oder mehrere Orte mit einer oder mehreren Maximaltemperaturen für die dritte Phase bestimmt werden.

7. System gemäß einem der Ansprüche 1 bis 6, wobei die Verarbeitungseinheit derart eingerichtet ist, dass sie auf eine Datenbank mit Temperaturänderungsraten und zugehörigen Temperaturdaten für drei Phasen einer Schaltanlage zugreift, und wobei die Bestimmung des Zustands der Schaltanlage die Verwendung der Datenbank mit Temperaturänderungsraten und zugehörigen Temperaturdaten umfasst.

8. System nach einem der Ansprüche 1 bis 7, wobei die Verarbeitungseinheit derart eingerichtet ist, dass sie einen Algorithmus für maschinelles Lernen implementiert, und wobei die Bestimmung des Zustands der Schaltanlage die Verwendung des Algorithmus für maschinelles Lernen umfasst, und wobei der Algorithmus für maschinelles Lernen auf der Grundlage von Temperaturänderungsraten und zugehörigen Temperaturdaten trainiert wurde.

9. System nach einem der Ansprüche 1 bis 8, wobei die Verarbeitungseinheit derart eingerichtet ist, dass sie auf eine Datenbank mit Temperaturänderungsraten und zugehörigen Temperaturdaten und zugehörigen elektrischen Stromdaten für drei Phasen einer Schaltanlage zugreift, und wobei die Bestimmung des Zustands der Schaltanlage die Verwendung der Datenbank mit Temperaturänderungsraten und zugehörigen Temperaturdaten und zugehörigen elektrischen Stromdaten umfasst.

10. System gemäß Anspruch 9, wobei die Bestimmung des Zustands der Schaltanlage einen Vergleich der n-1 ersten Temperaturänderungsraten für den einen oder die mehreren Orte der ersten Phase und der mindestens n-1 der n ersten Temperaturdaten für den einen oder die mehreren Orte der ersten Phase und der mindestens n-1 der n ersten elektrischen Stromdaten für den einen oder die mehreren Orte der ersten Phase mit der Datenbank der Temperaturänderungsraten und zugehörigen Temperaturdaten und zugehörigen elektrischen Stromdaten, und einen Vergleich der n-1 zweiten Temperaturänderungsraten für den einen oder die mehreren Orte der zweiten Phase und der mindestens n-1 der n zweiten Temperaturdaten für den einen oder die mehreren Orte der zweiten Phase und der mindestens n-1 der n zweiten elektrischen Stromdaten für den einen oder die mehreren Orte der zweiten Phase mit der Datenbank der Temperaturänderungsraten und den zugehörigen Temperaturdaten und zugehörigen elektrischen Stromdaten, und einen Vergleich der n-1 dritten Temperaturänderungsraten für den einen oder die mehreren Orte der dritten Phase und der mindestens n-1 der n dritten Temperaturdaten für den einen oder die mehreren Orte der dritten Phase und der mindestens n-1 der n dritten elektrischen Stromdaten für den einen oder die mehreren Orte der dritten Phase mit der Datenbank der Temperaturänderungsraten und zugehörigen Temperaturdaten und zugehörigen elektrischen Stromdaten.

11. System gemäß einem der Ansprüche 1 bis 8, wobei die Verarbeitungseinheit derart eingerichtet ist, dass sie einen Algorithmus für maschinelles Lernen implementiert, und wobei die Bestimmung des Zustands der Schaltanlage die Verwendung des Algorithmus für maschinelles Lernen umfasst, und wobei der Algorithmus für maschinelles Lernen auf der Grundlage von Temperaturänderungsraten und zugehörigen Temperaturdaten und zugehörigen elektrischen Stromdaten trainiert wurde.

12. Eine Schaltanlage (80) mit einem System (10) gemäß einem der Ansprüche 1 bis 11.

13. Verfahren (200) zum Überwachen einer dreiphasigen Schaltanlage, wobei das Verfahren umfasst:
- Erfassen (210) erster Temperaturdaten für jeden Ort mindestens eines Ortes einer ersten Phase einer Schaltanlage zu n Zeitpunkten durch einen oder mehrere von mindestens einem Temperatursensor;
- Erfassen (220) von zweiten Temperaturdaten für jeden Ort mindestens eines Ortes einer zweiten Phase der Schaltanlage zu den n Zeitpunkten durch einen oder mehrere der mindestens einen Temperatursensor;
- Erfassen (230) durch einen oder mehrere der mindestens einen Temperatursensor dritter Temperaturdaten für jeden Ort mindestens eines Ortes einer dritten Phase der Schaltanlage zu den n Zeitpunkten;
- Erfassen (240) durch einen oder mehrere erste Stromsensoren von mindestens drei Stromsensoren erster elektrischer Stromdaten für mindestens einen Ort der ersten Phase der Schaltanlage zu den n Zeitpunkten;
- Erfassen (250) durch einen oder mehrere zweite Stromsensoren der mindestens drei Stromsensoren zweiter elektrischer Stromdaten für mindestens einen Ort der zweiten Phase der Schaltanlage zu den n Zeitpunkten;
- Erfassen (260) durch einen oder mehrere dritte Stromsensoren der mindestens drei Stromsensoren von dritten elektrischen Stromdaten für mindestens einen Ort der dritten Phase der Schaltanlage zu den n Zeitpunkten;
- Bereitstellen (270) der ersten Temperaturdaten, der zweiten Temperaturdaten und der dritten Temperaturdaten durch den mindestens einen Temperatursensor an eine Verarbeitungseinheit;
- Bereitstellen (280) der ersten elektrischen Stromdaten, der zweiten elektrischen Stromdaten und der dritten elektrischen Stromdaten durch die mindestens drei Stromsensoren an eine Verarbeitungseinheit;
- Bestimmen (290) durch die Verarbeitungseinheit von n-1 ersten Temperaturänderungsraten für einen oder mehrere Orte des mindestens einen Ortes der ersten Phase in Bezug auf die n ersten Temperaturdaten für den einen oder die mehreren Orte der ersten Phase zu den n Zeitpunkten;
- Bestimmen (300) durch die Verarbeitungseinheit von n-1 zweiten Temperaturänderungsraten für einen oder mehrere Orte des mindestens einen Ortes der zweiten Phase in Bezug auf die n zweiten Temperaturdaten für den einen oder die mehreren Orte der zweiten Phase zu den n Zeitpunkten;
- Bestimmen (310) durch die Verarbeitungseinheit von n-1 dritten Temperaturänderungsraten für einen oder mehrere Orte des mindestens einen Ortes der dritten Phase in Bezug auf die n dritten Temperaturdaten für den einen oder die mehreren Orte der dritten Phase zu den n Zeitpunkten;
Bestimmen durch die Verarbeitungseinheit von n-1 ersten Korrelationsdatenpunkten, wobei jeder erste Korrelationsdatenpunkt eine Korrelation zwischen jeder ersten Temperaturänderungsrate der n-1 ersten Temperaturänderungsraten mit einer zugehörigen ersten Temperatur und zugehörigen ersten elektrischen Stromdaten ist, wobei die zugehörigen ersten elektrischen Stromdaten eine der beiden ersten elektrischen Stromdaten zu den beiden Zeitpunkten sind, zu denen die beiden ersten Temperaturdaten erfasst wurden, die zur Berechnung der zugehörigen ersten Temperaturänderungsrate verwendet wurden, oder die zugehörigen ersten elektrischen Stromdaten ein Durchschnitt der beiden ersten elektrischen Stromdaten zu den beiden Zeitpunkten sind, zu denen die beiden ersten Temperaturdaten erfasst wurden, die zur Berechnung der zugehörigen ersten Temperaturänderungsrate verwendet wurden, wobei für eine bestimmte erste Temperaturänderungsrate die zugehörige erste Temperatur eine erste Temperatur von zwei ersten Temperaturen ist, die zur Bestimmung der bestimmten ersten Temperaturänderungsrate verwendet wurden, oder eine zweite Temperatur der zwei ersten Temperaturen ist, die zur Bestimmung der bestimmten ersten Temperaturänderungsrate verwendet wurden, oder ein Durchschnitt der ersten Temperatur und der zweiten Temperatur der zwei ersten Temperaturen ist, die zur Bestimmung der bestimmten ersten Temperaturänderungsrate verwendet wurden;
Bestimmen von n-1 zweiten Korrelationsdatenpunkten durch die Verarbeitungseinheit, wobei jeder zweite Korrelationsdatenpunkt eine Korrelation zwischen jeder zweiten Temperaturänderungsrate der n-1- n zweiten Temperaturänderungsraten mit einer zugehörigen zweiten Temperatur und einem zugehörigen zweiten elektrischen Stromdatenpunkt ist, wobei die zugehörigen zweiten elektrischen Stromdaten eine der beiden zweiten elektrischen Stromdaten zu den beiden Zeitpunkten sind, zu denen die beiden zweiten Temperaturdaten erfasst wurden, die zur Berechnung der zugehörigen zweiten Temperaturänderungsrate verwendet wurden, oder die zugehörigen zweiten elektrischen Stromdaten ein Durchschnitt der beiden zweiten elektrischen Stromdaten zu den beiden Zeitpunkten sind, zu denen die beiden zweiten Temperaturdaten erfasst wurden, die zur Berechnung der zugehörigen zweiten Temperaturänderungsrate verwendet wurden, wobei für eine bestimmte zweite Temperaturänderungsrate die zugehörige zweite Temperatur eine erste Temperatur von zwei zweiten Temperaturen ist, die zur Bestimmung der bestimmten zweiten Temperaturänderungsrate verwendet wurden, oder eine zweite Temperatur der beiden zweiten Temperaturen ist, die zur Bestimmung der bestimmten zweiten Temperaturänderungsrate verwendet wurden, oder ein Durchschnitt der ersten Temperatur und der zweiten Temperatur der beiden zweiten Temperaturen ist, die zur Bestimmung der bestimmten zweiten Temperaturänderungsrate verwendet wurden;
Bestimmen von n-1 dritten Korrelationsdatenpunkten durch die Verarbeitungseinheit, wobei jeder dritte Korrelationsdatenpunkt eine Korrelation zwischen jeder dritten Temperaturänderungsrate der n-1 dritten Temperaturänderungsraten mit einer zugehörigen dritten Temperatur und einem zugehörigen dritten elektrischen Stromdatenpunkt ist, wobei die zugehörigen dritten elektrischen Stromdaten eine der beiden dritten elektrischen Stromdaten zu den beiden Zeitpunkten sind, zu denen die beiden dritten Temperaturdaten erfasst wurden, die zur Berechnung der zugehörigen dritten Temperaturänderungsrate verwendet wurden, oder die zugehörigen dritten elektrischen Stromdaten ein Durchschnitt der beiden dritten elektrischen Stromdaten zu den beiden Zeitpunkten sind, zu denen die beiden dritten Temperaturdaten erfasst wurden, die zur Berechnung der zugehörigen dritten Temperaturänderungsrate verwendet wurden, wobei für eine bestimmte dritte Temperaturänderungsrate die zugehörige dritte Temperatur eine erste Temperatur von zwei dritten Temperaturen ist, die zur Bestimmung der bestimmten dritten Temperaturänderungsrate verwendet wurden, oder eine zweite Temperatur der beiden dritten Temperaturen ist, die zur Bestimmung der bestimmten dritten Temperaturänderungsrate verwendet wurden, oder ein Durchschnitt der ersten Temperatur und der zweiten Temperatur der beiden dritten Temperaturen ist, die zur Bestimmung der bestimmten dritten Temperaturänderungsrate verwendet wurden.
- Bestimmen (320) eines Zustands der Schaltanlage durch die Verarbeitungseinheit, wobei die Bestimmung des Zustands der Schaltanlage die Verwendung der n-1 ersten Temperaturänderungsraten für den einen oder die mehreren Orte der ersten Phase und mindestens n-1 der n ersten Temperaturdaten für den einen oder die mehreren Orte der ersten Phase und der n-1 zweiten Temperaturänderungsraten für den einen oder die mehreren Orte der zweiten Phase und mindestens n-1 der n zweiten Temperaturdaten für den einen oder die mehreren Orte der zweiten Phase und die n-1 dritten Temperaturänderungsraten für den einen oder die mehreren Orte der dritten Phase und mindestens n-1 der n dritten Temperaturdaten für den einen oder die mehreren Orte der dritten Phase und mindestens n-1 der n ersten elektrischen Stromdaten für den einen oder die mehreren Orte der ersten Phase und mindestens n-1 der n zweiten elektrischen Stromdaten für den einen oder die mehreren Orte der zweiten Phase und mindestens n-1 der n dritten elektrischen Stromdaten für den einen oder die mehreren Orte der dritten Phase und die n-1 ersten Korrelationsdatenpunkte und die n-1 zweiten Korrelationsdatenpunkte und die n-1 dritten Korrelationsdatenpunkte; und
- Ausgeben (330) des ermittelten Zustands der Schaltanlage durch eine Ausgabeeinheit, wenn der ermittelte Zustand der Schaltanlage als nicht normal oder nicht intakt ermittelt wird.

14. Ein Computerprogrammelement zum Steuern eines Systems gemäß einem der Ansprüche 1 bis 11, das, wenn es von der Verarbeitungseinheit (30) ausgeführt wird, derart eingerichtet ist, dass es das Verfahren nach Anspruch 13 ausführt.

## Revendications

1. Système (10) pour surveiller un appareillage de commutation à trois phases, le système comprenant :
- au moins un capteur de température (20) ;
- une unité de traitement (30) ;
- au moins trois capteurs de courant (90, 100, 110) ; et
- une unité de sortie (40) ;
dans lequel un ou plusieurs de l'au moins un capteur de température est configuré pour acquérir des premières données de température pour chaque emplacement d'au moins un emplacement d'une première phase (50) d'un appareillage de commutation (80) à n points temporels ; dans lequel un ou plusieurs de l'au moins un capteur de température est configuré pour acquérir des deuxièmes données de température pour chaque emplacement d'au moins un emplacement d'une deuxième phase (60) de l'appareillage de commutation aux n points temporels ; dans lequel un ou plusieurs de l'au moins un capteur de température est configuré pour acquérir des troisièmes données de température pour chaque emplacement d'au moins un emplacement d'une troisième phase (70) de l'appareillage de commutation aux n points temporels ; dans lequel l'au moins un capteur de température est configuré pour fournir les premières données de température, les deuxièmes données de température, et les troisièmes données de température à l'unité de traitement ;
dans lequel un ou plusieurs premiers capteurs de courant des au moins trois capteurs de courant sont configurés pour acquérir des premières données de courant électrique pour au moins un emplacement de la première phase de l'appareillage de commutation aux n points temporels ; dans lequel un ou plusieurs deuxièmes capteurs de courant des au moins trois capteurs de courant sont configurés pour acquérir des deuxièmes données de courant électrique pour au moins un emplacement de la deuxième phase de l'appareillage de commutation aux n points temporels ; dans lequel un ou plusieurs troisièmes capteurs de courant des au moins trois capteurs de courant sont configurés pour acquérir des troisièmes données de courant électrique pour au moins un emplacement de la troisième phase de l'appareillage de commutation aux n points temporels ;
dans lequel les au moins trois capteurs de courant sont configurés pour fournir les premières données de courant électrique, les deuxièmes données de courant électrique, et les troisièmes données de courant électrique à l'unité de traitement ;
dans lequel l'unité de traitement est configurée pour déterminer n-1 premiers taux de changement de température pour un ou plusieurs emplacements de l'au moins un emplacement de la première phase par rapport aux n premières données de température pour l'un ou les plusieurs emplacements de la première phase aux n points temporels ;
dans lequel l'unité de traitement est configurée pour déterminer n-1 deuxièmes taux de changement de température pour un ou plusieurs emplacements de l'au moins un emplacement de la deuxième phase par rapport aux n deuxièmes données de température pour l'un ou les plusieurs emplacements de la deuxième phase aux n points temporels ;
dans lequel l'unité de traitement est configurée pour déterminer n-1 troisièmes taux de changement de température pour un ou plusieurs emplacements de l'au moins un emplacement de la troisième phase par rapport aux n troisièmes données de température pour l'un ou les plusieurs emplacements de la troisième phase aux n points temporels ;
dans lequel l'unité de traitement est configurée pour déterminer n-1 premiers points de données de corrélation, dans lequel chaque premier point de données de corrélation est une corrélation entre chaque premier taux de changement de température des n-1 premiers taux de changement de température avec une première température associée et une première donnée de courant électrique associée, dans lequel la première donnée de courant électrique associée est une des deux premières données de courant électrique aux deux points temporels auxquels les deux premières données de température ont été acquises qui ont été utilisées pour calculer le premier taux associé de changement de température ou la première donnée de courant électrique associée est une moyenne des deux premières données de courant électrique aux deux points temporels auxquels les deux premières données de température ont été acquises qui ont été utilisées pour calculer le premier taux associé de changement de température, dans lequel, pour un premier taux particulier de changement de température, la première température associée est une première température de deux premières températures utilisées pour déterminer le premier taux particulier de changement de température ou est une seconde température des deux premières températures utilisées pour déterminer le premier taux particulier de changement de température ou est une moyenne de la première température et de la seconde température des deux premières températures utilisées pour déterminer le premier taux particulier de changement de température ;
dans lequel l'unité de traitement est configurée pour déterminer n-1 deuxièmes points de données de corrélation, dans lequel chaque deuxième point de données de corrélation est une corrélation entre chaque deuxième taux de changement de température des n-1 deuxièmes taux de changement de température avec une deuxième température associée et une deuxièmes donnée de courant électrique associée, dans lequel la deuxième donnée de courant électrique associée est une des deux deuxièmes données de courant électrique aux deux points temporels auxquels les deux deuxièmes données de température ont été acquises qui ont été utilisées pour calculer le deuxième taux associé de changement de température ou la deuxième donnée de courant électrique associée est une moyenne des deux deuxièmes données de courant électrique aux deux points temporels auxquels les deux deuxièmes données de température ont été acquises qui ont été utilisées pour calculer le deuxième taux associé de changement de température, dans lequel pour un deuxième taux particulier de changement de température la deuxième température associée est une première température de deux deuxièmes températures utilisées pour déterminer le deuxième taux particulier de changement de température ou est une seconde température des deux deuxièmes températures utilisées pour déterminer le deuxième taux particulier de changement de température ou est une moyenne de la première température et de la seconde température des deux deuxièmes températures utilisées pour déterminer le deuxième taux particulier de changement de température ;
dans lequel l'unité de traitement est configurée pour déterminer n-1 troisièmes points de données de corrélation, dans lequel chaque troisième point de données de corrélation est une corrélation entre chaque troisième taux de changement de température des n-1 troisièmes taux de changement de température avec une troisième température associée et une troisième donnée de courant électrique associée, dans lequel la troisième donnée de courant électrique associée est une des deux troisièmes données de courant électrique aux deux points temporels auxquels les deux troisièmes données de température ont été acquises qui ont été utilisées pour calculer le troisième taux associé de changement de température ou la troisième donnée de courant électrique associée est une moyenne des deux troisièmes données de courant électrique aux deux points temporels auxquels les deux troisièmes données de température ont été acquises qui ont été utilisées pour calculer le troisième taux associé de changement de température, dans lequel, pour un troisième taux particulier de changement de température, la troisième température associée est une première température de deux troisièmes températures utilisées pour déterminer le troisième taux particulier de changement de température ou est une seconde température des deux troisièmes températures utilisées pour déterminer le troisième taux particulier de changement de température ou est une moyenne de la première température et de la seconde température des deux troisièmes températures utilisées pour déterminer le troisième taux particulier de changement de température ;
dans lequel l'unité de traitement est configurée pour déterminer un état de l'appareillage de commutation, dans lequel la détermination de l'état de l'appareillage de commutation comprend l'utilisation des n-1 premiers taux de changement de température pour l'un ou les plusieurs emplacements de la première phase et d'au moins n-1 des n premières données de température pour l'un ou les plusieurs emplacements de la première phase et des n-1 deuxièmes taux de changement de température pour l'un ou les plusieurs emplacements de la deuxième phase et d'au moins n-1 des n deuxièmes données de température pour l'un ou les plusieurs emplacements de la deuxième phase et des n-1 troisièmes taux de changement de température pour l'un ou les plusieurs emplacements de la troisième phase et d'au moins n-1 des n troisièmes données de température pour l'un ou les plusieurs emplacements de la troisième phase et d'au moins n-1 des n premières données de courant électrique pour l'un ou les plusieurs emplacements de la première phase et d'au moins n-1 des n deuxièmes données de courant électrique pour l'un ou les plusieurs emplacements de la deuxième phase et d'au moins n-1 des n troisièmes données de courant électrique pour l'un ou les plusieurs emplacements de la troisième phase et des n-1 premiers points de données de corrélation et des n-1 deuxièmes points de données de corrélation et des n-1 troisièmes points de données de corrélation ; et
dans lequel l'unité de sortie est configurée pour sortir l'état déterminé de l'appareillage de commutation lorsque l'état déterminé de l'appareillage de commutation est déterminé comme n'étant pas normal ou n'étant pas bon.

2. Système selon la revendication 1, dans lequel l'un ou les plusieurs de l'au moins un capteur de température est configuré pour acquérir des premières données de température pour chaque emplacement de l'au moins un emplacement de la première phase à m points temporels, dans lequel m est supérieur à n, et dans lequel les n points temporels sont des points temporels consécutifs des m points temporels ; dans lequel l'un ou les plusieurs de l'au moins un capteur de température est configuré pour acquérir des deuxièmes données de température pour chaque emplacement de l'au moins un emplacement de la deuxième phase aux m points temporels, dans lequel m est supérieur à n, et dans lequel les n points temporels sont des points temporels consécutifs des m points temporels ; dans lequel l'un ou les plusieurs de l'au moins un capteur de température est configuré pour acquérir des troisièmes données de température pour chaque emplacement de l'au moins un emplacement de la troisième phase aux m points temporels, dans lequel m est supérieur à n, et dans lequel les n points temporels sont des points temporels consécutifs des m points temporels.

3. Système selon de quelconques des revendications 1 et 2, dans lequel chacun des n-1 premiers taux de changement de température est déterminé pour des données de température consécutives des n premières données de température pour l'un ou les plusieurs emplacements de la première phase ; dans lequel chacun des n-1 deuxièmes taux de changement de température est déterminé pour des données de température consécutives des n deuxièmes données de température pour l'un ou les plusieurs emplacements de la deuxième phase ; et dans lequel chacun des n-1 troisièmes taux de changement de température est déterminé pour des données de température consécutives des n troisièmes données de température pour l'un ou les plusieurs emplacements de la troisième phase.

4. Système selon de quelconques des revendications 1 à 3, dans lequel l'au moins un capteur de température comprend une ou plusieurs caméras infrarouges, et dans lequel les données de température pour chaque emplacement de l'au moins un emplacement pour chaque phase aux n points temporels est déterminé à partir d'une ou de plusieurs images infrarouges acquises à chacun des n points temporels.

5. Système selon la revendication 1 à 3, dans lequel l'au moins un capteur de température comprend une pluralité de capteurs de point situés à l'au moins un emplacement des trois phases, et dans lequel les données de température pour l'au moins un emplacement aux n points temporels pour chaque phase sont acquises par un ou plusieurs capteurs de point à chacun des n points temporels.

6. Système selon de quelconques des revendications 1 à 5, dans lequel l'un ou les plusieurs emplacements de l'au moins un emplacement de la première phase sont déterminés comme étant un ou plusieurs emplacements avec une ou plusieurs températures maximums pour la première phase ; dans lequel l'un ou les plusieurs emplacements de l'au moins un emplacement de la deuxième phase sont déterminés comme étant un ou plusieurs emplacements avec une ou plusieurs températures maximums pour la deuxième phase ; et dans lequel l'un ou les plusieurs emplacements de l'au moins un emplacement de la troisième phase sont déterminés comme étant un ou plusieurs emplacements avec une ou plusieurs températures maximums pour la troisième phase.

7. Système selon de quelconques des revendications 1 à 6, dans lequel l'unité de traitement est configurée pour accéder à une base de données de taux de changement de données de température et de données de température associées pour trois phases d'un appareillage de commutation, et dans lequel la détermination de l'état de l'appareillage de commutation comprend l'utilisation de la base de données de taux de changement de données de température et de données de température associées.

8. Système selon de quelconques des revendications 1 à 7, dans lequel l'unité de traitement est configurée pour mettre en œuvre un algorithme d'apprentissage machine, et dans lequel la détermination de l'état de l'appareillage de commutation comprend l'utilisation de l'algorithme d'apprentissage machine, et dans lequel l'algorithme d'apprentissage machine a été entraîné sur la base de taux de changement de données de température et de données de température associées.

9. Système selon de quelconques des revendications 1 à 8, dans lequel l'unité de traitement est configurée pour accéder à une base de données de taux de changement de données de température et de données de température associées et de données de courant électrique associées pour trois phases d'un appareillage de commutation, et dans lequel la détermination de l'état de l'appareillage de commutation comprend l'utilisation de la base de données de taux de changement de données de température et de données de température associées et de données de courant électrique associées.

10. Système selon la revendication 9, dans lequel la détermination de l'état de l'appareillage de commutation comprend une comparaison des n-1 premiers taux de changement de température pour l'un ou les plusieurs emplacements de la première phase et des au moins n-1 des n premières données de température pour l'un ou les plusieurs emplacements de la première phase et des au moins n-1 des n premières données de courant électrique pour l'un ou les plusieurs emplacements de la première phase à la base de données de taux de changement de données de température et de données de température associées et de données de courant électrique associées, et une comparaison des n-1 deuxièmes taux de changement de température pour l'un ou les plusieurs emplacements de la deuxième phase et des au moins n-1 des n deuxièmes données de température pour l'un ou les plusieurs emplacements de la deuxième phase et des au moins n-1 des n deuxièmes données de courant électrique pour l'un ou les plusieurs emplacements de la deuxième phase à la base de données de taux de changement de données de température et de données de température associées et de données de courant électrique associées, et une comparaison des n-1 troisièmes taux de changement de température pour l'un ou les plusieurs emplacements de la troisième phase et des au moins n-1 des n troisièmes données de température pour l'un ou les plusieurs emplacements de la troisième phase et des au moins n-1 des n troisièmes données de courant électrique pour l'un ou les plusieurs emplacements de la troisième phase à la base de données de taux de changement de données de température et de données de température associées et de données de courant électrique associées.

11. Système selon de quelconques des revendications 1 à 8, dans lequel l'unité de traitement est configurée pour mettre en œuvre un algorithme d'apprentissage machine, et dans lequel la détermination de l'état de l'appareillage de commutation comprend l'utilisation de l'algorithme d'apprentissage machine, et dans lequel l'algorithme d'apprentissage machine a été entraîné sur la base de taux de changement de données de température et de données de température associées et de données de courant électrique associées.

12. Appareillage de commutation (80), comprenant un système (10) selon de quelconques des revendications 1 à 11.

13. Procédé (200) pour surveiller un appareillage de commutation à trois phases, le procédé comprenant :
- l'acquisition (210), par un ou plusieurs d'au moins un capteur de température, de premières données de température pour chaque emplacement d'au moins un emplacement d'une première phase d'un appareillage de commutation à n points temporels ;
- l'acquisition (220), par un ou plusieurs de l'au moins un capteur de température, de deuxièmes données de température pour chaque emplacement d'au moins un emplacement d'une deuxième phase de l'appareillage de commutation aux n points temporels ;
- l'acquisition (230), par un ou plusieurs de l'au moins un capteur de température, de troisièmes données de température pour chaque emplacement d'au moins un emplacement d'une troisième phase de l'appareillage de commutation aux n points temporels ;
- l'acquisition (240), par un ou plusieurs premiers capteurs de courant d'au moins trois capteurs de courant, de premières données de courant électrique pour au moins un emplacement de la première phase de l'appareillage de commutation aux n points temporels ;
- l'acquisition (250), par un ou plusieurs deuxièmes capteurs de courant des au moins trois capteurs de courant, de deuxièmes données de courant électrique pour au moins un emplacement de la deuxième phase de l'appareillage de commutation aux n points temporels ;
- l'acquisition (260), par un ou plusieurs troisièmes capteurs de courant des au moins trois capteurs de courant, de troisièmes données de courant électrique pour au moins un emplacement de la troisième phase de l'appareillage de commutation aux n points temporels ;
- la fourniture (270), par l'au moins un capteur de température, des premières données de température, des deuxièmes données de température, et des troisièmes données de température à une unité de traitement ;
- la fourniture (280), par les au moins trois capteurs de courant, des premières données de courant électrique, des deuxièmes données de courant électrique, et des troisièmes données de courant électrique à une unité de traitement ;
- la détermination (290), par l'unité de traitement, de n-1 premiers taux de changement de température pour un ou plusieurs emplacements de l'au moins un emplacement de la première phase par rapport aux n premières données de température pour l'un ou les plusieurs emplacements de la première phase aux n points temporels ;
- la détermination (300), par l'unité de traitement, de n-1 deuxièmes taux de changement de température pour un ou plusieurs emplacements de l'au moins un emplacement de la deuxième phase par rapport aux n deuxièmes données de température pour l'un ou les plusieurs emplacements de la deuxième phase aux n points temporels ;
- la détermination (310), par l'unité de traitement, de n-1 troisièmes taux de changement de température pour un ou plusieurs emplacements de l'au moins un emplacement de la troisième phase par rapport aux n troisièmes données de température pour l'un ou les plusieurs emplacements de la troisième phase aux n points temporels ;
la détermination, par l'unité de traitement, de n-1 premiers points de données de corrélation, dans lequel chaque premier point de données de corrélation est une corrélation entre chaque premier taux de changement de température des n-1 premiers taux de changement de température avec une première température associée et une première donnée de courant électrique associée, dans lequel la première donnée de courant électrique associée est une des deux premières données de courant électrique aux deux points temporels auxquels les deux premières données de température ont été acquises qui ont été utilisées pour calculer le premier taux associé de changement de température ou la première donnée de courant électrique associée est une moyenne des deux premières données de courant électrique aux deux points temporels auxquels les deux premières données de température ont été acquises qui ont été utilisées pour calculer le premier taux associé de changement de température, dans lequel, pour un premier taux particulier de changement de température, la première température associée est une première température de deux premières températures utilisées pour déterminer le premier taux particulier de changement de température ou est une seconde température des deux premières températures utilisées pour déterminer le premier taux particulier de changement de température ou est une moyenne de la première température et de la seconde température des deux premières températures utilisées pour déterminer le premier taux particulier de changement de température ;
la détermination, par l'unité de traitement, de n-1 deuxièmes points de données de corrélation, dans lequel chaque deuxième point de données de corrélation est une corrélation entre chaque deuxième taux de changement de température des n-1 deuxièmes taux de changement de température avec une deuxième température associée et une deuxièmes donnée de courant électrique associée, dans lequel la deuxième donnée de courant électrique associée est une des deux deuxièmes données de courant électrique aux deux points temporels auxquels les deux deuxièmes données de température ont été acquises qui ont été utilisées pour calculer le deuxième taux associé de changement de température ou la deuxième donnée de courant électrique associée est une moyenne des deux deuxièmes données de courant électrique aux deux points temporels auxquels les deux deuxièmes données de température ont été acquises qui ont été utilisées pour calculer le deuxième taux associé de changement de température, dans lequel pour un deuxième taux particulier de changement de température la deuxième température associée est une première température de deux deuxièmes températures utilisées pour déterminer le deuxième taux particulier de changement de température ou est une seconde température des deux deuxièmes températures utilisées pour déterminer le deuxième taux particulier de changement de température ou est une moyenne de la première température et de la seconde température des deux deuxièmes températures utilisées pour déterminer le deuxième taux particulier de changement de température ;
la détermination, par l'unité de traitement, de n-1 troisièmes points de données de corrélation, dans lequel chaque troisième point de données de corrélation est une corrélation entre chaque troisième taux de changement de température des n-1 troisièmes taux de changement de température avec une troisième température associée et une troisième donnée de courant électrique associée, dans lequel la troisième donnée de courant électrique associée est une des deux troisièmes données de courant électrique aux deux points temporels auxquels les deux troisièmes données de température ont été acquises qui ont été utilisées pour calculer le troisième taux associé de changement de température ou la troisième donnée de courant électrique associée est une moyenne des deux troisièmes données de courant électrique aux deux points temporels auxquels les deux troisièmes données de température ont été acquises qui ont été utilisées pour calculer le troisième taux associé de changement de température, dans lequel, pour un troisième taux particulier de changement de température, la troisième température associée est une première température de deux troisièmes températures utilisées pour déterminer le troisième taux particulier de changement de température ou est une seconde température des deux troisièmes températures utilisées pour déterminer le troisième taux particulier de changement de température ou est une moyenne de la première température et de la seconde température des deux troisièmes températures utilisées pour déterminer le troisième taux particulier de changement de température ;
- la détermination (320), par l'unité de traitement, d'un état de l'appareillage de commutation, dans lequel la détermination de l'état de l'appareillage de commutation comprend l'utilisation des n-1 premiers taux de changement de température pour l'un ou les plusieurs emplacements de la première phase et d'au moins n-1 des n premières données de température pour l'un ou les plusieurs emplacements de la première phase et des n-1 deuxièmes taux de changement de température pour l'un ou les plusieurs emplacements de la deuxième phase et d'au moins n-1 des n deuxièmes données de température pour l'un ou les plusieurs emplacements de la deuxième phase et des n-1 troisièmes taux de changement de température pour l'un ou les plusieurs emplacements de la troisième phase et d'au moins n-1 des n troisièmes données de température pour l'un ou les plusieurs emplacements de la troisième phase et d'au moins n-1 des n premières données de courant électrique pour l'un ou les plusieurs emplacements de la première phase et d'au moins n-1 des n deuxièmes données de courant électrique pour l'un ou les plusieurs emplacements de la deuxième phase et d'au moins n-1 des n troisièmes données de courant électrique pour l'un ou les plusieurs emplacements de la troisième phase et des n-1 premiers points de données de corrélation et des n-1 deuxièmes points de données de corrélation et des n-1 troisièmes points de données de corrélation ; et
- la sortie (330), par une unité de sortie, de l'état déterminé de l'appareillage de commutation lorsque l'état déterminé de l'appareillage de commutation est déterminé comme n'étant pas normal ou n'étant pas bon.

14. Élément de programme informatique, pour commander un système selon de quelconques des revendications 1 à 11, qui, lorsqu'il est exécuté par l'unité de traitement (30), est configuré pour effectuer le procédé de la revendication 13.
